(19) Europäisches Patentamt
European Patent Office
Office européen des brevets

(11) EP 4 282 575 A1

(12) **EUROPEAN PATENT APPLICATION**
published in accordance with Art. 153(4) EPC

(43) Date of publication:
**29.11.2023 Bulletin 2023/48**

(21) Application number: **22742583.2**

(22) Date of filing: **18.01.2022**

(51) International Patent Classification (IPC):
***B23K 35/363*** (2006.01) ***H01L 33/48*** (2010.01)

(52) Cooperative Patent Classification (CPC):
**B23K 35/3601; H01L 33/48**

(86) International application number:
**PCT/JP2022/001680**

(87) International publication number:
**WO 2022/158461 (28.07.2022 Gazette 2022/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.01.2021 JP 2021006770**

(71) Applicant: **NAGASE CHEMTEX CORPORATION**
**Osaka-shi, Osaka 550-8668 (JP)**

(72) Inventors:
- **MIYAUCHI, Kazuhiro**
  **Tatsuno-shi, Hyogo 679-4124 (JP)**
- **HIRAOKA, Takashi**
  **Tatsuno-shi, Hyogo 679-4124 (JP)**
- **SHINSEI, Eiji**
  **Tatsuno-shi, Hyogo 679-4124 (JP)**
- **YOSHIMATSU, Shuhei**
  **Tatsuno-shi, Hyogo 679-4124 (JP)**

(74) Representative: **Schön, Christoph**
**Dr. Schön, Neymeyr & Partner mbB**
**Bavariaring 26**
**80336 München (DE)**

# (54) FLUX SHEET FOR SEMICONDUCTOR TRANSFER

(57) It is an object of the present invention to provide a flux sheet excellent in shock absorbency and stickiness/adhesiveness and excellent in water washability having the flux activity. To achieve the above-described object, a flux sheet for semiconductor transfer containing a (A) water-soluble sticking agent and a (B) water-soluble plasticizer (excluding the component (A)) is provided. The flux sheet for semiconductor transfer of the present invention allows providing a flux sheet excellent in shock absorbency and stickiness/adhesiveness and excellent in solderability and water washability.

Fig. 1

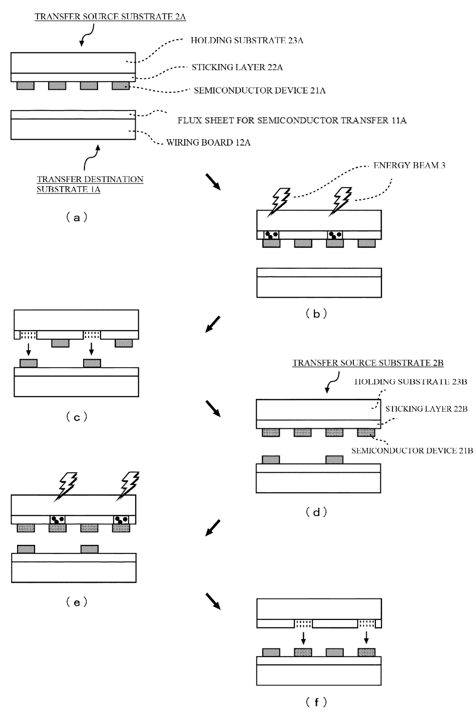


EP 4 282 575 A1

## Description

TECHNICAL FIELD

The present invention relates to a flux sheet for semiconductor transfer.

BACKGROUND ART

In the manufacture of an electronic component, such as a semiconductor device and a display element, for the purpose of preventing adhesion of a foreign matter or efficient manufacture of a semiconductor chip or an image display device, a material with an adhesive layer (pressure-sensitive adhesive layer) is used.
For example, Patent Document 1 proposes a method of producing a display unit using a light emitting diode (LED). In the producing method, a method including dicing and enlarged transfer using a temporarily holding member with an adhesive layer (pressure-sensitive adhesive layer) after forming a large number of LED elements that become pixels on one wafer is disclosed.
Patent Document 2 proposes a method in which LED elements are separated from a substrate using laser beam when enlarged transfer is performed.
Patent Document 1: JP-A-2002-261335

Patent Document 2: JP-A-2010-161221

DISCLOSURE OF THE INVENTION

PROBLEMS TO BE SOLVED BY THE INVENTION

However, in the transfer using laser beam, when the substrate having the surface on which the LED elements adhere is irradiated with the laser beam, the LED elements are rapidly separated in some cases. Therefore, the separated LED elements are broken due to collision with a member of a transfer destination in some cases. Alternatively, the LED elements collide with the member of the transfer destination, and the LED elements fail to be arranged at desired positions due to the rebound in some cases.
Therefore, a flux sheet that does not cause the damage or positional displacement of elements regardless of the collision of the LED elements is desired.
Furthermore, by electrically connecting each of the LED elements to the substrate by reflow soldering after the transfer, the manufacturing efficiency can be improved.
Therefore, in the manufacture of the semiconductor device, a member excellent in shock absorbency and stickiness/adhesiveness and facilitated in removal by water washing after reflow and handling is desired.
It is an object of the present invention to provide a flux sheet excellent in shock absorbency and stickiness/adhesiveness and excellent in solderability and water washability.

SOLUTIONS TO THE PROBLEMS

According to one aspect of the present invention, a flux sheet for semiconductor transfer containing a (A) water-soluble sticking agent and a (B) water-soluble plasticizer (excluding the component (A)) is provided. In the flux sheet for semiconductor transfer, the (B) water-soluble plasticizer has a viscosity of 50000 mPa.s or less at ordinary temperature (25°C), and a ratio ((B)/(A)) of a content of the (B) water-soluble plasticizer to a content of the (A) water-soluble sticking agent is 0.2 or more.
According to the flux sheet for semiconductor transfer of the present invention, since the water-soluble plasticizer of 50000 mPa.s or less at ordinary temperature (25°C) is contained in a predetermined ratio to the content of the water-soluble sticking agent, the shock absorbency and the stickiness/adhesiveness of the flux sheet for semiconductor transfer are improved, and the occurrence of damage or positional displacement of a device can be suppressed in the manufacture of the semiconductor device. Additionally, according to the flux sheet for semiconductor transfer of the present invention, the satisfactory soldering can be performed, and the removal by water washing after the reflow and the handling are facilitated.
According to one aspect of the present invention, a flux sheet for semiconductor transfer containing a (A) water-soluble sticking agent and a (B) water-soluble plasticizer (excluding the component (A)) is provided. In the flux sheet for semiconductor transfer, the (B) water-soluble plasticizer is in a liquid state at ordinary temperature (25°C) and has a

molecular weight of 5000 or less, and a ratio ((B)/(A)) of a content of the (B) water-soluble plasticizer to a content of the (A) water-soluble sticking agent is 0.2 or more.

According to the flux sheet for semiconductor transfer of the present invention, since the water-soluble plasticizer that is in a liquid state and has the molecular weight of 5000 or less is contained in a predetermined ratio to the content of the water-soluble sticking agent, the shock absorbency and the stickiness/adhesiveness of the flux sheet for semiconductor transfer are improved, and the occurrence of damage or positional displacement of a device can be suppressed in the manufacture of the semiconductor device. Additionally, according to the flux sheet for semiconductor transfer of the present invention, the satisfactory soldering can be performed, and the removal by water washing after the reflow and the handling are facilitated.

The flux sheet for semiconductor transfer according to the one aspect of the present invention preferably contains a (C) fluxing agent (excluding the component (A) and the component (B)).

According to the above-described embodiment, the flux sheet excellent in shock absorbency and stickiness/adhesiveness and excellent in water washability having the flux activity can be provided.

In the flux sheet for semiconductor transfer according to the one aspect of the present invention, the (A) water-soluble sticking agent preferably contains at least one water-soluble sticking agent selected from the group consisting of a vinyl alcohol-based polymer, a vinylpyrrolidone-based polymer, an acrylic-based polymer, and saccharides.

According to the above-described embodiment, the flux sheet excellent in tackiness and stickiness and excellent in water washability can be provided. When the vinyl alcohol-based polymer is selected, since the (A) water-soluble sticking agent has the flux activity, the flux sheet that is excellent in tackiness, stickiness, and water washability and has the flux activity can be provided.

In the flux sheet for semiconductor transfer according to the one aspect of the present invention, the vinyl alcohol-based polymer preferably has an oxyalkylene structure.

The above-described embodiment can provide the flux sheet excellent in stickiness and water washability provided by the improved solubility in water at low temperature.

In the flux sheet for semiconductor transfer according to the one aspect of the present invention, the (B) water-soluble plasticizer is preferably in a liquid state at ordinary temperature (25°C).

According to the above-described embodiment, since the (B) water-soluble plasticizer is in a liquid state at ordinary temperature (25°C), mixing with the (A) water-soluble sticking agent is facilitated compared with the (B) water-soluble plasticizer of a solid, and the flux sheet excellent in manufacturability can be provided.

In the flux sheet for semiconductor transfer according to the one aspect of the present invention, the (B) water-soluble plasticizer preferably has a boiling point at 120°C or more.

According to the above-described embodiment, since the vaporization is less likely to be caused in the transfer step, the flux sheet in which the physical property is less likely to change in the transfer can be provided.

In the flux sheet for semiconductor transfer according to the one aspect of the present invention, the (B) water-soluble plasticizer preferably contains at least one selected from glycerin, diglycerin, polyethylene glycol, ethylene glycol, propylene glycol, and polypropylene glycol.

According to the above-described embodiment, since any of glycerin, diglycerin, polyethylene glycol, ethylene glycol, propylene glycol, and polypropylene glycol has a high boiling point, and are therefore less likely to be vaporized in the reflow, formation of bubbles of vapor (what is called "voids") in the flux sheet can be suppressed. Additionally, an effect of exhibiting the excellent water washability after the reflow can be provided.

In the flux sheet for semiconductor transfer according to the one aspect of the present invention, the (A) water-soluble sticking agent preferably includes saccharides, and the (B) water-soluble plasticizer (excluding the component (A)) preferably has a boiling point at 200°C or more.

According to the above-described embodiment, the flux sheet excellent in tackiness and stickiness and excellent in solderability and water washability can be provided. Additionally, the flux sheet that exhibits satisfactory solderability without vaporization of the plasticizer even in the reflow soldering step can be provided.

In the flux sheet for semiconductor transfer according to the one aspect of the present invention, the (C) fluxing agent is preferably a compound having a carboxyl group.

According to the above-described embodiment, since the (C) fluxing agent becomes easy to be dissolved in water, the flux sheet excellent in water washability can be provided.

In the flux sheet for semiconductor transfer according to the one aspect of the present invention, the semiconductor is preferably a light-emitting diode (LED).

The above-described embodiment can provide the flux sheet that is excellent in shock absorbency and stickiness/adhesiveness capable of avoiding a damage due to collision with a member of a transfer destination of the LED element and poor mounting at the desired position of the LED element due to rebound in a transfer step, and the flux sheet is excellent also in water washability in a washing step.

According to one aspect of the present invention, a method for manufacturing an electronic component is provided, and the method uses the above-described flux sheet for semiconductor transfer.

According to the method for manufacturing an electronic component of the present invention, since the flux sheet excellent in shock absorbency and stickiness/adhesiveness and excellent in water washability is used, an effect of avoiding the poor soldering or the like can be provided. Additionally, when the flux sheet itself has the flux activity, since it is not necessary to additionally apply the fluxing agent over the substrate or the like in the manufacture of an electronic component, an effect of shortening the manufacturing process is provided.

EFFECTS OF THE INVENTION

According to the present invention, the flux sheet excellent in shock absorbency and stickiness/adhesiveness and excellent in solderability and water washability can be provided.

BRIEF DESCRIPTION OF THE DRAWINGS

Fig. 1 is a schematic diagram illustrating a contactless transfer step.
Fig. 2 is a schematic diagram illustrating a contact transfer step.
Fig. 3 is a diagram illustrating recommended conditions of JEDEC in a reflow soldering step for an evaluation of flux activity.

DESCRIPTION OF PREFERRED EMBODIMENTS

[Flux Sheet for Semiconductor Transfer]

A flux sheet for semiconductor transfer of the present invention has shock absorbency for receiving semiconductor devices, such as LED elements, separated from a transfer source substrate by an energy beam (laser or the like) or the like, and has stickiness/tackiness for temporarily securing the received semiconductor devices at desired positions of a substrate and stickiness/adhesiveness to the substrate. The flux sheet for semiconductor transfer of the present invention softens and melts at a reflow temperature in a reflow step, and has flux activity that removes or reduces oxides on a solder surface, thus avoiding a poor joint between the semiconductor devices and a circuit. Furthermore, in the flux sheet for semiconductor transfer of the present invention, flux sheet residues melted in the reflow step are dissolved in water, and can be removed in a water washing step.
With a sheet form, since steps of applying over a wiring board and drying can be omitted and the handling is facilitated, the operation efficiency can be improved compared with a case of using a liquid flux. Since the amount of liquid components can be significantly reduced in the sheet compared with the liquid flux, the conveyance efficiency is improved, and satisfactory storage stability can be obtained.
In the sheet, since a flux can be equally supplied to each electrode of the substrate, the flux activity is stably developed at each electrode, and the satisfactory solderability is exhibited. In attaching the sheet, since a surface on which a component or the like is mounted (upper surface of sheet, upper surface of liquid flux) is flat, the component can be stably placed compared with application of a liquid flux.
The shape of the flux sheet for semiconductor transfer of the present invention is not specifically limited. As the shape of the flux sheet for semiconductor transfer of the present invention in plan view, examples include a polygon (for example, a rectangular shape, a quadrangular shape, and a triangular shape), a circular shape, an oval shape, and an indefinite shape. The shape of the flux sheet for semiconductor transfer of the present invention can even have a desired shape, such as a shape corresponding to a shape of an adherend substrate. Processing into a desired shape may be performed using a publicly known method, such as cutting. Furthermore, after forming into a roll shape, cutting by a necessary amount and using it are allowed.
While a thickness of the flux sheet for semiconductor transfer of the present invention is not specifically limited, for example, 1 μm or more is preferable, 3 μm or more is more preferable, and 5 μm or more is further preferable.
The thickness of 1 μm or more of the flux sheet for semiconductor transfer of the present invention improves the shock absorbency, and it is preferable.
The upper limit value of the thickness of the flux sheet for semiconductor transfer of the present invention is preferably 500 μm or less, more preferably 100 μm or less, and further preferably 50 μm or less.
When the thickness of the flux sheet for semiconductor transfer of the present invention is 500 μm or less, a softening and melting time of the flux sheet can be reduced, and the amount of flux sheet residue is small. Therefore, the time for a flux step and a washing step can be shortened, and it is preferable.
It is preferred that the thickness of the flux sheet for semiconductor transfer of the present invention is appropriately selected depending on a relation with a height of a bump formed at the semiconductor device. When the flux

sheet is thicker than the height of the bump, since a bottom surface and a side surface of the semiconductor device are in contact with the flux sheet, rebound of the semiconductor device can be suppressed.

In high speed mounting of the semiconductor devices, (1) sinking of the semiconductor device into the flux sheet, (2) collision of the bump of the semiconductor device with a substrate electrode, and (3) rebounding of the semiconductor device due to the impact of the collision are caused. When the thickness of the flux sheet is extremely thick compared with the height of the bump of the semiconductor device, or when the flux sheet is hard, the phenomenon (2) is not caused, and the bump of the semiconductor device stops inside the flux sheet before reaching the substrate electrode, or rebounds inside the flux sheet. Among the above-described behaviors, in the behavior other than the behavior in which the semiconductor device stops inside the flux sheet, when the flux sheet does not have an effect of suppressing the rebound, positional displacement of the semiconductor device is generated, thus causing poor mounting.

The flux sheet for semiconductor transfer of the present invention contains a water-soluble plasticizer (B), and when the water-soluble plasticizer (B) is a liquid component and contained by a high ratio, the flux sheet for semiconductor transfer of the present invention becomes high in characteristics as a liquid. Therefore, at an early stage of the rebound after the sinking of the semiconductor device, the upper surface of the flux sheet is wet at the side surface of the bump of the semiconductor device and the side surface of the semiconductor device, and an effect of suppressing the rebound of the semiconductor device and the damage of the semiconductor device is provided by surface tension due to the wet and the sticking force.

When the semiconductor device sinks deep into the flux sheet, since the upper surface of the semiconductor device is covered with the flux sheet, and the resistance against the rebound further increases, the positional displacement in the high speed mounting is significantly decreased.

For the effect of suppressing the semiconductor device rebound, at the early stage of the rebound, the rebound suppressing effect increases in the order from "the flux sheet is wet at the bump side surface of the semiconductor device (wet at the bump of the semiconductor device)," "the flux sheet is wet at the semiconductor device side surface (wet at the bump of the semiconductor device, the bottom surface of the semiconductor device, the side surface of the semiconductor device)," "the upper surface of the semiconductor device is covered with the flux sheet (wet at the bump of the semiconductor device, the bottom surface of the semiconductor device, the side surface of the semiconductor device, and the upper surface of the semiconductor device)."

The ratio of the thickness of the flux sheet for semiconductor transfer of the present invention to the height of the bump of the semiconductor device (flux sheet thickness/bump height) is preferably 1.0 or more, more preferably 1.2 or more, and further preferably 1.5 or more from the aspect of the positional displacement in mounting the semiconductor device and the damage of the semiconductor device. When the ratio of the thickness of the flux sheet for semiconductor transfer of the present invention to the height of the bump is 1.0 or more, the bump of the semiconductor device is less likely to be displaced from the desired position of the substrate electrode in a semiconductor device mounting step, and it is preferable.

In a reflow soldering step after mounting the semiconductor device without the positional displacement, it is necessary that the semiconductor device sinks downward (again) due to the softened flux sheet to bring the bump of the semiconductor device into contact with the substrate electrode, and the bump of the semiconductor device is wetted with the electrode at a temperature of melting point or more. When the thickness of the flux sheet is significantly thick compared with the height of the semiconductor device (shortest distance between the bump lower surface of the semiconductor device and the semiconductor device upper surface), a distance of the sinking (again) of the semiconductor device is long, and it is concerned that the semiconductor device swings during the sinking, thereby increasing the displacement from the substrate electrode. When the positional displacement increases, a self-alignment effect of the reflow soldering step is not capable of performing the position correction, thus causing the poor joint.

Accordingly, the ratio of the thickness of the flux sheet for semiconductor transfer of the present invention to the height of the bump (flux sheet thickness/semiconductor device bump height) is preferably 5.0 or less, more preferably 3.6 or less, and further preferably 2.3 or less from the aspect of the positional displacement due to the sinking of the semiconductor device in the reflow soldering step after mounting the semiconductor device without the positional displacement. When the ratio of the thickness of the flux sheet for semiconductor transfer of the present invention to the height of the bump of the semiconductor device is 3.0 or less, the positional displacement between the bump of the semiconductor device and the substrate electrode in the sinking in the reflow soldering step after mounting the semiconductor device at the desired position can be suppressed.

The height of the bump formed at the semiconductor device is not specifically limited, but is, for example, 1 μm or more and 50 μm or less. The lower limit value of the bump height is preferably 1 μm or more, more preferably 2 μm or more, and further preferably 3 μm or more. The upper limit value of the bump height is preferably 50 μm or less, more preferably 30 μm or less, and further preferably 20 μm or less.

The flux sheet for semiconductor transfer of the present invention preferably contains a (A) water-soluble sticking agent and a (B) water-soluble plasticizer, and a (C) fluxing agent as necessary.

The content of the component (A) is, for example, 10 mass% or more and 75 mass% or less based on the

whole flux sheet. The component (A) of 10 mass% or more is preferable for sheet formability. The component (A) of 75 mass% or less is preferable for the stickiness and the adhesiveness.

The lower limit value of the content of the component (A) is preferably 20 mass% or more, more preferably 25 mass% or more, and further preferably 30 mass% or more from the aspect of the improvement of sheet formability.

The upper limit value of the content of the component (A) is preferably 70 mass% or less, more preferably 60 mass% or less, and further preferably 55 mass% or less from the aspect of the stickiness and the adhesiveness.

The content of the component (B) is preferably 30 mass% or more, more preferably 40 mass% or more, and further preferably 50 mass% or more based on the component (A).

The content of the component (B) of 30 mass% or more is preferable for the improvement of avoiding the positional displacement in the semiconductor device mounting step from the aspect of the stickiness, the adhesiveness, the surface tension, and rheological properties. With the above-described range, the characteristics as a liquid increase, and the wettability to the semiconductor device improves. Consequently, the excellent surface tension is developed, thus allowing suppression of the rebound of the semiconductor device. Additionally, in the above-described range, since the polymer chain of the water-soluble sticking agent can freely move, the excellent shock absorbency is provided. It is seen from this that in the rheological property depending on frequency, the value G" (E") tends to increase as the frequency becomes high while the value G' (E') is approximately constant, and as a result, tan$\delta$ as an index of impact absorption increases, thus providing the excellent shock absorbency.

The content of the component (B) is preferably 300 mass% or less, more preferably 250 mass% or less, and further preferably 200 mass% or less based on the component (A).

The component (B) of 300 mass% or less is preferable from the aspect of sheet formability.

The content ratio of the component (C) fluxing agent can be appropriately selected depending on whether the component (A) or the component (B) has a fluxing action or not and the content ratios thereof.

To develop the fluxing action and join the device and the wiring board, for example, the lower limit value of the content ratio of the component (C) fluxing agent is preferably 1.0 mass% or more, more preferably 2.0 mass% or more, and further preferably 3.0 mass% or more based on the whole flux sheet. The lower limit value of the content ratio of the component (C) fluxing agent of 1.0 mass% or more is preferable for removing an oxide film on the solder surface.

The upper limit value of the content ratio of the component (C) fluxing agent is preferably 20.0 mass% or less, more preferably 15.0 mass% or less, and further preferably 10.0 mass% or less based on the whole flux sheet. When the upper limit value of the content ratio of the component (C) fluxing agent is 20.0 mass% or less, remaining of the fluxing agent in the substrate can be suppressed, and metal corrosion and ion migration are avoided, thus it is preferable.

The following describes each of the components contained in the flux sheet for semiconductor transfer of the present invention.

The flux sheet for semiconductor transfer is simply referred to as a "flux sheet" in other words.

[Component (A) Water-Soluble Sticking Agent]

The component (A) water-soluble sticking agent is a main component constituting the flux sheet, and contains a polymer as a main component. The component (A) water-soluble sticking agent is a component having water solubility, and is a component developing stickiness alone or with an added water-soluble plasticizer. Here, the water solubility means that a material dissolves in an aqueous solution of 1 mass% at ordinary temperature (25°C) without turbidity. The stickiness means that for a sheet made of the component (A) water-soluble sticking agent alone or a sheet produced by adding the (B) water-soluble plasticizer by 30 pts.mass or 50 pts.mass, when at ordinary temperature (25°C), the sheet (1 cm $\times$ 5 cm $\times$ 10 $\mu$m) is pressed against a PET film (surface on which release process is not performed), then the PET film on which the sheet is attached is cut out in a strip shape, and the PET film cut out in the strip shape is perpendicularly suspended, the sheet is not peeled off from the PET film. Since the flux sheet for semiconductor transfer of the present invention contains the component (A), the tackiness and the stickiness (pressure-sensitive adhesiveness) to the semiconductor device, the stickiness/adhesiveness to the substrate, the decomposition inhibiting property or the melting property, and the water solubility at a reflow temperature are improved.

The polymer constituting the component (A) includes one in which the polymer itself has the tackiness and the stickiness, and/or one that develops the tackiness and the stickiness by forming a gel.

The flux sheet of the present invention melts in the reflow step, and brings the bump of the semiconductor device into contact with the electrode of the substrate. Therefore, the polymer constituting the component (A) of the flux sheet melts at the temperature of the reflow soldering step. The softening temperature of the polymer constituting the component (A) is not specifically limited insofar as the flux sheet melts in the reflow soldering step.

For example, assume a case in which the ratio (B/A) of the content of the (B) water-soluble plasticizer to the content of the (A) water-soluble sticking agent in the flux sheet significantly decreases due to the evaporation or the like of the (B) water-soluble plasticizer (liquid component) during the reflow soldering step. The softening temperature of the polymer constituting the component (A) is preferably 200°C or less, more preferably 150°C or less, further preferably

100°C or less, and most preferably 80°C or less from the aspect that the semiconductor device sinks into the flux sheet due to the softened (A) water-soluble sticking agent even when the (B) water-soluble plasticizer disappears during the reflow soldering step.

Meanwhile, for example, the softening temperature of the polymer constituting the component (A) is preferably 40°C or more, more preferably 100°C or more, further preferably 150°C or more, and most preferably 200°C or more from the aspect that forming into a sheet is allowed even when a large amount of the (B) water-soluble plasticizer is contained.

Since the polymer constituting the component (A) dissolves in water, it can be easily removed from the substrate by water washing after the reflow step.

The solubility of the polymer constituting the component (A) is not specifically limited insofar as the washing with water can be performed. For example, the solubility of the polymer constituting the component (A) to water is preferably 0.05 g/g-$H_2O$ or more, more preferably 0.10 g/g-$H_2O$ or more, and further preferably 0.30 g/g-$H_2O$ or more at 90°C.

With 0.05 g/g-$H_2O$ or more, the washing can be performed in a short time even at ordinary temperature, and the washing residue can be removed or significantly reduced, thus it is preferable.

In the component (A), for example, when the weight average molecular weight exceeds $5.0 \times 10^5$, since it takes a long time for dissolving in water by washing, the washing residue is easily generated. Therefore, from the aspect of shortening the washing time and reducing the washing residue, it is preferred that the component (A) is decomposed to reduce the molecular weight, thereby improving the dissolution rate. A method for reducing the molecular weight is not specifically limited insofar as a workpiece, such as a semiconductor device and a substrate, is not damaged by the method. For example, when the component (A) is a natural polymer, various kinds of publicly known hydrolases can be included.

For example, when the component (A) contains a polymer of $\alpha$-glucose, such as starch and pullulan, or/and its derivative, the hydrolase, such as amylase, glucoamylase, and prunase, can be included. For example, in a case of a natural polymer containing a polymer of $\beta$-glucose, such as carboxymethyl cellulose (CMC), or/and its derivative, cellulase and the like can be included. For example, in a case of a natural polymer derived from amino acid, such as silk, protease and the like can be included. When the hydrolases are used, it is preferred to perform the washing at the optimal pH in the optimal temperature region developing the high enzyme activity, and depending on the enzyme, the enzyme activity can be more increased by adding an additive, such as $Ca^{2+}$ or the like.

From the aspect of improving the sheet formability, a weight average molecular weight Mw of the polymer constituting the component (A) is preferably $3.0 \times 10^3$ or more, more preferably $1.0 \times 10^4$ or more, and further preferably $1.0 \times 10^5$ or more. Since the sheet formability significantly depends on the ratio (B)/(A) of the content of the (B) water-soluble plasticizer to the content of the (A) water-soluble sticking agent, for example, when (B)/(A) is 0.5 or more, $1.0 \times 10^5$ or more is preferable for avoiding degradation of the sheet formability. For example, when the weight average molecular weight Mw of the polymer constituting the component (A) exceeds $5.0 \times 10^5$, as described above, from the aspect of shortening the washing time and reducing the washing residue, it is preferred to reduce the molecular weight of the component (A) by hydrolysis or the like, thereby improving the dissolution rate in water.

The weight average molecular weight Mw of the polymer constituting the component (A) is preferably $5.0 \times 10^4$ or less, more preferably $4.0 \times 10^4$ or less, and further preferably $3.0 \times 10^4$ or less from the aspect that the bump of the semiconductor device easily promptly contacts the substrate electrode by the sinking of the semiconductor device into the flux sheet due to the softened water-soluble sticking agent and the aspect of the excellent water washability.

A molecular weight distribution Mw/Mn (here, Mn indicates a number average molecular weight) of the polymer constituting the component (A) is not specifically limited. For example, the molecular weight distribution Mw/Mn is preferably 1.5 or more, and more preferably 1.8 or more.

The molecular weight distribution Mw/Mn is preferably 30 or less, more preferably 15 or less, and further preferably 8 or less.

With the molecular weight distribution Mw/Mn in the above-described range, the satisfactory film can be formed, and the physical property variation in the sheet surface can be lowered (uniform development of physical property).

For the weight average molecular weight of the polymer, gel permeation chromatography (GPC method) was used.

As measuring conditions, the measurement was performed by the gel permeation chromatography method (GPC method), tetrahydrofuran (THF) was used for an eluent, and RI was used for a detector. The molecular weight of a component (A) is a polystyrene conversion value.

As the polymer constituting the component (A), at least one selected from the group consisting of a vinyl alcohol-based polymer, a vinylpyrrolidone-based polymer, and an acrylic-based polymer, and saccharides, which are excellent in tackiness and stickiness, is preferably used.

When the polymer constituting the component (A) has an acid group (carboxyl group or the like), a basic group (amino group or the like), or an alcoholic hydroxyl group, the polymer itself has the flux activity.

Therefore, as the component (A), the vinyl alcohol-based polymer is more preferably used because it has the flux activity.

<Vinyl Alcohol-Based Polymer>

In the present invention, the vinyl alcohol-based polymer means a polymer having a repeating unit of hydroxyethylene represented by a general formula (1).

Hereinafter, the structure represented by the general formula (1) is referred to as a vinyl alcohol repeating unit in other words.

[Chem. 1]

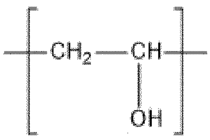

(1)

The vinyl alcohol-based polymer may have a homopolymer structure in which the repeating unit includes only the vinyl alcohol repeating unit, and may have a copolymer structure including another repeating unit.

Hereinafter, the vinyl alcohol-based polymer with the homopolymer structure including only the vinyl alcohol repeating unit is simply referred to as a "homopolymer" in other words, and the vinyl alcohol-based polymer with the copolymer structure including the other repeating unit is simply referred to as a "copolymer" in other words.

The vinyl alcohol-based polymer is generally produced by homopolymerizing or copolymerizing a monomer (for example, vinyl acetate) in which the hydroxyl group of vinyl alcohol is protected, and then performing denaturation (for example, hydrolysis) to remove the protected group.

Therefore, examples of the other repeating unit other than the vinyl alcohol repeating unit can include the unit in which a repeating unit before the denaturation remains. Examples of the repeating unit before the denaturation include repeating units induced from vinyl formate, vinyl acetate, vinyl propionate, vinyl butyrate, vinyl isobutyrate, vinyl pivalate, vinyl versatate, vinyl caproate, vinyl caprylate, vinyl laurylate, vinyl palmitate, vinyl stearate, vinyl oleate, vinyl trifluoroacetate, vinyl benzoate, butyl vinyl ether, and trimethylsilyl vinyl ether.

Hereinafter, the repeating unit in the vinyl alcohol-based polymer in a state where the functional group before the denaturation remains without being denatured is referred to a "native repeating unit" in other words.

The vinyl alcohol-based polymer may include one or two or more kinds of remaining native repeating units.

The vinyl alcohol-based polymer is typically produced by saponifying a vinyl acetate-based polymer. Therefore, the vinyl alcohol-based copolymer, which is easily available, in which a vinyl acetate polymer having the repeating unit before the denaturation induced from vinyl acetate is denatured is preferably used.

In the vinyl alcohol-based polymer including the vinyl alcohol repeating unit and the native repeating unit, the solubility in water and the stickiness (pressure-sensitive adhesiveness) are affected by the saponification degree and the polymerization degree.

Here, the saponification degree in the vinyl alcohol-based polymer including the vinyl alcohol repeating unit and the native repeating unit is a ratio of the number of the vinyl alcohol repeating units to the number of all the repeating units (ratio [number of vinyl alcohol repeating units]/{ [number of vinyl alcohol repeating units] + [number of native repeating units]}).

In the vinyl alcohol-based polymer including the vinyl alcohol repeating unit and the native repeating unit, the solubility in water decreases in any case of the excessively high and the excessively low saponification degree. Also with the high polymerization degree, the solubility in water decreases.

Therefore, in the vinyl alcohol-based polymer including also the native repeating unit, the saponification degree and the polymerization degree are selected depending on the type of the native repeating unit.

For example, the saponification degree is preferably 30% or more, more preferably 40% or more, and further preferably 50% or more.

For example, the saponification degree is preferably 90% or less, more preferably 80% or less, and further preferably 70% or less.

Within the above-described range, difficulty in dissolution in water due to crystallization or difficulty in dissolution in water due to the small number of hydrophilic groups does not occur, and it is preferable for use.

The vinyl alcohol-based polymer may include one or two or more kinds of another repeating unit other than the vinyl alcohol repeating unit or the native repeating unit. Examples of the other repeating unit other than the vinyl alcohol

repeating unit or the native repeating unit include repeating units induced from ethylene, (meth)acrylic acid, maleic acid, vinylpyrrolidone, an amino alkyl ester of (meth)acrylic acid, a monomer represented by general formula (2) (for example, oxyethylene monoallyl ether and ethyl carbitol (meth)acrylate), and the like.

Hereinafter, the other repeating unit other than the vinyl alcohol repeating unit or the native repeating unit is referred to as a "third repeating unit" in other words.

The measurement of the saponification degree can be performed based on $^1$H-NMR when the third repeating unit (oxyalkylene structure or the like) is included, and based on Japanese Industrial Standard K6726 when the third repeating unit is not included.

[Chem. 2]

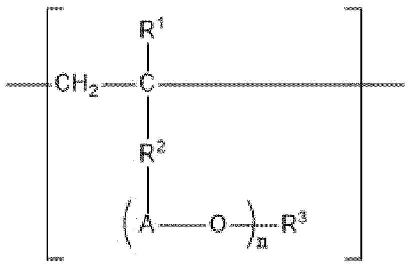

(2)

(In the formula, $R^1$ and $R^3$ independently represent a hydrogen atom or an organic group, $R^2$ represents an ether bond, an ester bond, an amide bond, alkylene having 1 to 6 carbon atoms, or a composite group or single bond thereof, and A represents an alkylene group having 2 to 22 carbon atoms. ***n*** represents an integer of 1 or more.)

$R^1$ in the general formula (2) represents a hydrogen atom or an organic group having 1 to 20 carbon atoms, and the organic group obviously may include one or two or more among elements of O, N, S, Si, and P.

Examples of the organic group of $R^1$ can include alkyl group, acyl group, acyloxy group, alkoxycarbonyl group, alkyl ester group (acyloxy-substituted hydrocarbyl group and alkoxycarbonyl-substituted hydrocarbyl group), alkylamide alkylene group, and sulfonate base.

Examples of alkyl group include methyl group, ethyl group, n-propyl group, i-propyl group, butyl group, pentyl group, and hexyl group.

Examples of acyl group include methyl carbonyl group, ethyl carbonyl group, n-propyl carbonyl group, i-propyl carbonyl group, butyl carbonyl group, pentyl carbonyl group, and hexyl carbonyl group.

Examples of alkyl ester group include methyloxycarbonylmethylene group, methylcarbonyloxymethylene group, ethyloxycarbonylethylene group, and ethylcarbonyloxyethylene group.

Examples of alkylamide alkylene group include N,N'-dimethylamide alkylene group and N,N'-diethylamide alkylene group.

$R^1$ is preferably hydrogen atom or alkyl group, acyl group, alkyl ester group, or alkylamide alkylene group having 1 to 10 carbon atoms, more preferably hydrogen atom or methyl group, and further preferably hydrogen atom.

When $R^1$ is hydrogen atom, the glass-transition temperature of the polymer can be lowered, and it is preferable.

$R^2$ in the general formula (2) represents an ether bond (-O-), an ester bond (-COO-, -OCO-), an amide bond (-NHCO-, -OCNH-), alkylene having 1 to 6 carbon atoms, or a composite group or single bond thereof.

$R^3$ in the general formula (2) represents a hydrogen atom or an organic group having 1 to 20 carbon atoms, and the organic group obviously may include one or two or more among elements of O, N, S, Si, and P.

Examples of the organic group of $R^3$ can include alkyl group, acyl group, alkoxycarbonyl group, alkyl ester group (acyloxy-substituted hydrocarbyl group and alkoxycarbonyl-substituted hydrocarbyl group), alkylamide group, alkylamide alkylene group, and sulfonate base.

Examples of alkyl group include methyl group, ethyl group, n-propyl group, i-propyl group, butyl group, pentyl group, and hexyl group.

Examples of acyl group include methyl carbonyl group, ethyl carbonyl group, n-propyl carbonyl group, i-propyl carbonyl group, butyl carbonyl group, pentyl carbonyl group, and hexyl carbonyl group.

Examples of alkyl ester group include methyloxycarbonylmethylene group, methylcarbonyloxymethylene group, ethyloxycarbonylethylene group, and ethylcarbonyloxyethylene group.

Examples of alkylamide alkylene group include N,N'-dimethylamide alkylene group and N,N'-diethylamide alkylene group.

$R^3$ is preferably hydrogen atom or alkyl group, acyl group, alkyl ester group, or alkylamide alkylene group having

1 to 10 carbon atoms, and more preferably hydrogen atom or methyl group.

A in the general formula (2) represents a linear or branched alkylene group having 2 to 22 carbon atoms.

In the general formula (2), when ***n*** is 2 or more, a plurality of A may be mutually same or mutually different. The carbon atoms of A is preferably 10 or less, more preferably 4 or less, further preferably 3 or less, and especially preferably 2.

Examples of A can include dimethylene (ethylene), trimethylene, methyl ethylene, tetramethylene, 1-methyl propylene, 2-methyl propylene, and 1-ethyl ethylene.

In the oxyalkylene structure, the oxyalkylene group with the small number of carbon atoms of alkylene group that acts as a hydrophobic group is hydrophilic compared with the oxyalkylene group having the large number of carbon atoms.

Accordingly, in the general formula (2), the oxyalkylene structure represented as "AO" is most preferably an oxyethylene structure.

In the general formula (2), a repetition count ***n*** represents the number of the oxyalkylene structures represented as "AO" as a hydrophilic group. Therefore, generally, increase in the number of ***n*** improves the hydrophilicity of the repeating unit represented by the general formula (2).

Accordingly, the repetition count ***n*** in the general formula (2) is preferably 2 or more, more preferably 5 or more, and further preferably 6 or more. The repetition count ***n*** in the general formula (2) is preferably 300 or less, more preferably 200 or less, further preferably 65 or less, and especially preferably 20 or less.

With the repeating unit count ***n*** of the oxyalkylene group within the above-described range, the solubility in water at low temperature can be improved, and the stickiness can be improved.

The content ratio of the third repeating unit is not specifically limited insofar as the vinyl alcohol-based polymer exhibits the tackiness and the stickiness (pressure-sensitive adhesiveness), and can be dissolved in water.

Accordingly, the ratio of the third repeating unit is selected depending on the type of the third repeating unit from the aspect of the tackiness, the stickiness (pressure-sensitive adhesiveness), and the water solubility.

For example, the ratio of the third repeating unit in the vinyl alcohol-based polymer ("third repeating unit" × 100/"vinyl alcohol repeating unit" + "native repeating unit" + "third repeating unit") is preferably 0.5 mol% or more, more preferably 3.0 mol% or more, and further preferably 5.0 mol% or more.

With 0.5 mol% or more, the solubility in water at low temperature and the miscibility with the water-soluble plasticizer (B) are satisfactory, and it is preferable for use.

The ratio of the third repeating unit in the vinyl alcohol-based polymer is preferably 20 mol% or less, more preferably 10 mol% or less, and further preferably 5 mol% or less.

With 20 mol% or less, the sheet formability is satisfactory, and it is preferable for use.

The content ratio of the vinyl alcohol repeating unit in the vinyl alcohol-based polymer is not specifically limited insofar as the vinyl alcohol-based polymer exhibits the stickiness (pressure-sensitive adhesiveness), and can be dissolved in water. For example, the ratio of the vinyl alcohol repeating unit in the vinyl alcohol-based polymer is preferably 20 mol% or more, more preferably 30 mol% or more, and further preferably 40 mol% or more.

With 20 mol% or more, the stickiness is satisfactory, and it is preferable.

The ratio of the vinyl alcohol repeating unit in the vinyl alcohol-based polymer is preferably 90 mol% or less, more preferably 80 mol% or less, and further preferably 60 mol% or less.

With 90 mol% or less, the stickiness is satisfactory, and it is preferable.

In the vinyl alcohol-based polymer, a polymer including a repeating unit induced from a monomer having a carboxyl group is improved in flux activity. A polymer including a repeating unit induced from a monomer having a (poly)oxyalkylene structure is improved in water solubility.

Therefore, as the third repeating unit, a repeating unit induced from a monomer having a carboxyl group or a (poly)oxyalkylene structure is preferable.

When the third repeating unit is water-soluble, the water solubility of the vinyl alcohol-based polymer can be improved without depending on the vinyl alcohol repeating unit. Therefore, from the aspect of the solubility in water, the saponification degree of the vinyl alcohol-based polymer can be lowered compared with the saponification degree of the vinyl alcohol-based polymer without the third repeating unit.

Furthermore, as a result of the decrease of the ratio of the crystalline vinyl alcohol repeating unit, the glass-transition temperature of a vinyl alcohol-based copolymer can be lowered, and the tackiness and the stickiness can be improved.

Accordingly, the third repeating unit is more preferably a repeating unit induced from a monomer having a (poly)oxyalkylene structure, and further preferably a repeating unit represented by the general formula (2).

A vinyl alcohol homopolymer or a vinyl alcohol-based copolymer may have a structure represented by a general formula (3) at at least one end of the polymer.

[Chem. 3]

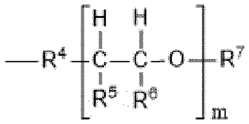

(3)

(In the formula, $R^4$ represents an ether bond, an ester bond, an amide bond, alkylene having 1 to 6 carbon atoms, or a composite group or single bond thereof, $R^5$ and $R^6$ independently represent a hydrogen atom or an alkyl group having 1 to 10 carbon atoms, and $R^7$ represents a hydrogen atom or an organic group having 1 to 20 carbon atoms. ***m*** represents an integer of 1 or more.)

$R^4$, $R^7$ and ***m*** in the general formula (3) are as described for $R^3$, $R^3$ and ***n*** in the general formula (2), respectively.

$R^5$ and $R^6$ are independently a hydrogen atom or an alkyl group having 1 to 10 carbon atoms, and when ***m*** is 2 or more, a plurality of $R^5$ or a plurality of $R^6$ may be same or different.

Examples of alkyl group in $R^5$ and $R^6$ include methyl group, ethyl group, n-propyl group, i-propyl group, butyl group, pentyl group, and hexyl group.

From the aspect improving the water solubility of the vinyl alcohol-based polymer, the hydrogen atom is preferable.

As the vinyl alcohol-based polymer, one polymer selected from the vinyl alcohol homopolymers, the vinyl alcohol-based copolymers, or the vinyl alcohol-based polymers having the structure represented by the general formula (3) at at least one end may be used alone, or two or more polymers selected therefrom may be used. In the case of using the two or more polymers, two or more selected from the vinyl alcohol-based copolymers or two or more from the vinyl alcohol-based polymers having the structure represented by the general formula (3) at at least one end may be used.

<Vinylpyrrolidone-Based Polymer>

In the present invention, the vinylpyrrolidone-based polymer means a polymer having a structure represented by a general formula (4) as a main repeating unit.

[Chem. 4]

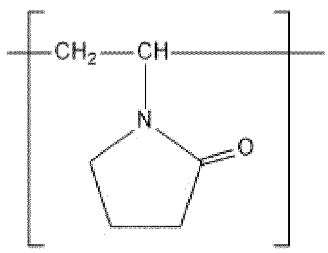

(4)

The vinylpyrrolidone-based polymer may be a vinylpyrrolidone homopolymer, or may be a copolymer.

Examples of the copolymer component can include ethylene, (meth)acrylic acid, maleic acid, vinylpyrrolidone, an amino alkyl ester of (meth)acrylic acid, and a monomer represented by general formula (2) (for example, oxyethylene monoallyl ether and ethyl carbitol (meth)acrylate).

As the other repeating unit, since the flux activity can be provided to a polymer including a repeating unit induced from a monomer having a carboxyl group, it is preferable.

The ratio of the copolymer component in the vinylpyrrolidone-based polymer is not specifically limited insofar as it does not hinder the effects of the present invention. For example, the ratio of the copolymer component is preferably 30 mol% or less, more preferably 10 mol% or less, and further preferably 5 mol% or less.

With 30 mol% or less, the solubility in water is satisfactory without hindering formation of strong hydrogen bond with water accompanied by heat generation, and it is preferable.

The vinylpyrrolidone homopolymer is preferable because it is excellent in water solubility and stickiness.

<Acrylic-Based Polymer>

The acrylic-based polymer means a polymer having a structure in which a monomer with a (meth)acryloyloxy structure is additionally polymerized as a main repeating unit.

The acrylic-based polymer having water solubility preferably includes a hydroxyl group, a carboxyl group (salt of carboxyl group, for example, including a functional group of sodium carboxylate, ammonium carboxylate, or the like), an oxyalkylene group (for example, oxyethylene structure or oxypropylene structure), or an amino group (salt of amino group, for example, including a functional group of ammonium hydrochloride, ammonium sulphate, or the like).

When the acrylic-based polymer includes a hydroxyl group, a carboxyl group, or an amino group, the fluxing action is provided, and it is more preferable.

The acrylic-based polymer used in the present invention is used alone or includes the water-soluble plasticizer (B), and therefore provided with the stickiness (pressure-sensitive adhesiveness). Accordingly, the glass-transition temperature is preferably 120°C or less, more preferably 80°C or less, and further preferably 50°C or less.

The method for measuring the glass-transition temperature was based on JIS K6240 (DSC method).

Examples of the acrylic-based polymer include one obtained by copolymerizing one or two or more selected from hydrophilic acrylic acid-based monomers (acrylic acid, carboxyethyl acrylate, hydroxyethyl acrylate, 2-(2-ethoxyethoxy)ethyl acrylate, polyoxyethylene acrylate, polyoxypropylene acrylate, polyoxyethylene polyoxypropylene acrylate, and the like) and one or two or more selected from alkyl ester acrylate (methyl acrylate, ethyl acrylate, propylene acrylate, butyl acrylate, 2-ethylhexyl acrylate, and the like) and the like, a methacrylic acid-based monomer (methacrylic acid, methacrylic acid alkyl ester, methacrylic acid hydroxyalkyl ester, poly(oxyalkylene)methacrylate, and the like), and acrylonitrile.

In the acrylic-based polymer, the ratio of the monomer other than the hydrophilic acrylic acid-based monomer is not specifically limited insofar as it is water-soluble, and the glass-transition temperature is preferably 120°C or less. For example, 30 mol% or less is preferable, 10 mol% or less is more preferable, and 5 mol% or less is further preferable.

Examples of the acrylic-based polymer include one obtained by copolymerizing a hydrophilic acrylic acid-based monomer inducing a homopolymer having low glass-transition temperature with a (meth)acrylic acid-based monomer and (meth)alkyl ester acrylate, which have a polar group (carboxyl group and hydroxyl group) or the like improving the stickiness (pressure-sensitive adhesiveness) to a metal, in combination.

<Saccharides>

In the present invention, the saccharides mean polymers having the above-described properties of the water-soluble sticking agent.

Examples can include pullulan as a repeating unit represented by a general formula (5), hydroxyethyl cellulose as a repeating unit represented by a general formula (6), and carboxymethyl cellulose and starch as a repeating unit represented by a general formula (7).

[Chem. 5]

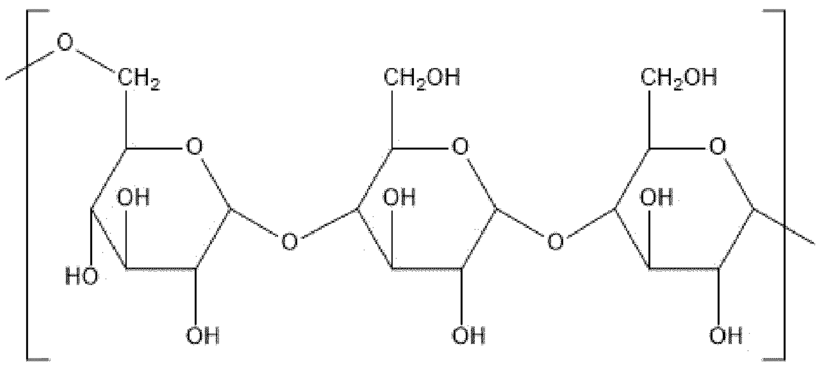

(5)

[Chem. 6]

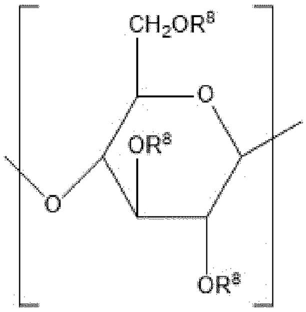

(6)

(In the formula, $R^8$ independently represents a hydrogen atom or mono- or poly-oxyalkylene group having a hydrogen atom at an end.)

[Chem. 7]

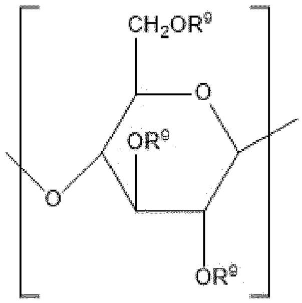

(7)

(In the formula, $R^9$ independently represents a hydrogen atom, $CH_2COONa$, or $CH_2COONH_4$.)

[Component (B) Water-Soluble Plasticizer]

The (B) water-soluble plasticizer acts as a plasticizer of the component (A), and has an action that more softens the component (A) as a main component of the flux sheet of the present invention. This allows absorbing the impact at the contact of the semiconductor device separated from the transfer source substrate and the flux sheet of the present invention, thereby avoiding the positional displacement due to the damage and the rebound of the semiconductor device.
Therefore, for more softening the component (A), the (B) water-soluble plasticizer is preferably in a liquid state at a temperature used in the transfer step. For example, the (B) water-soluble plasticizer is preferably in a liquid state at ordinary temperature (25°C).
The (B) water-soluble plasticizer in the present invention is one other than the component (A). The (B) water-soluble plasticizer in the present invention includes water.
While the boiling point of the (B) water-soluble plasticizer is not specifically limited, it is, for example, 120°C or more, preferably 150°C or more, and further preferably 180°C or more. When the boiling point of the (B) water-soluble plasticizer is 120°C or more, it is less likely to vaporize in the transfer step, thus providing an effect that the physical property of the flux sheet for semiconductor transfer of the present invention in the transfer is less likely to change.
Furthermore, since the reflow step is performed on the flux sheet for semiconductor transfer of the present invention, the (B) water-soluble plasticizer is preferably a plasticizer that is a liquid having a vapor pressure at reflow temperature less than atmospheric pressure. Since the plasticizer that is a liquid having a vapor pressure at reflow temperature less than atmospheric pressure does not vaporize in the reflow, formation of bubbles of vapor (what is called "voids") in the flux sheet can be suppressed.
While the upper limit value of the boiling point of the (B) water-soluble plasticizer is not specifically limited, it is, for example, 500°C or less.
The (B) water-soluble plasticizer is removed by water washing after the reflow step. Therefore, the (B) water-soluble plasticizer can be used without restriction insofar as it dissolves in water. Since the water washing can be efficiently performed, the solubility in water of the water-soluble plasticizer is preferably 0.10 g/g-$H_2O$ or more, more

preferably 0.30 g/g-$H_2O$ or more, and further preferably 0.50 g/g-$H_2O$ or more at ordinary temperature (25°C).

It is preferred that the (B) water-soluble plasticizer does not hinder the melting property of the component (A) in the reflow step, and not only the water-soluble plasticizer has a property excellent in water solubility, but also an aqueous solution of the water-soluble plasticizer has a low viscosity.

Therefore, the (B) water-soluble plasticizer is preferably in a liquid state at ordinary temperature (25°C). Its viscosity is preferably 50000 mPa.s or less, more preferably 40000 mPa.s or less, further preferably 1000 mPa.s or less, and still further preferably 600 mPa.s or less at ordinary temperature (25°C). While the lower limit value of the viscosity is not specifically limited, it is preferably 0.8 mPa.s or more, and more preferably 1.0 mPa.s or more.

Since the viscosity of the aqueous solution depends on the molecular weight of solute, for example, the molecular weight of a compound used for the water-soluble plasticizer is preferably 5000 or less, more preferably 3000 or less, further preferably 1000 or less, still further preferably 800 or less, and especially preferably 600 or less. In the description of the present invention, the molecular weight of the water-soluble plasticizer with a distribution in molecular weight means a weight average molecular weight.

For the type of the (B) water-soluble plasticizer, a water-soluble plasticizer that does not hinder the effect of the present invention provided by the reduction of the solvent solubility and the melting property by the reaction or interaction with the component (A) is selected.

For example, when the component (A) and the component (B) are reacted, not only the flux activity is reduced by dissipation of the reactive functional group, but also the solvent solubility, the melting property, and the surface tension are hindered when a three-dimensional crosslinked structure is formed.

Examples of the water-soluble plasticizer can include monovalent or polyvalent alcohol and alkanolamine.

More specifically, examples of the water-soluble plasticizer can include glycerin, diglycerin, ethylene glycol, diethylene glycol, propane-1,2-diol, 1,3-propanediol, diethylene glycol monomethyl ether, ethanolamine, and triethanolamine.

Examples of a water-soluble polymer plasticizer can include polyethylene glycol, terminated monoalkoxy polyethylene glycol, terminated dialkoxy polyethylene glycol, polyglycerin, propylene glycol, and polypropylene glycol.

Here, the (B) water-soluble plasticizer is preferably glycerin, diglycerin, polyethylene glycol, polypropylene glycol, and triethanolamine. Glycerin, diglycerin, polyethylene glycol, polypropylene glycol, and triethanolamine are excellent in miscibility with water, and have high boiling points. Therefore, the melting property of the flux sheet and the surface tension in the reflow step, and the water washability in the washing step are excellent. Glycerin, diglycerin, polyethylene glycol, and polypropylene glycol, which are facilitated in availability and handleability, are more preferable, and glycerin and polyethylene glycol are further preferable.

The ratio ((B)/(A)) of the content of the (B) water-soluble plasticizer to the content of the (A) water-soluble sticking agent is 0.2 or more. When this value is not satisfied, the sufficient transferability is not obtained, thus resulting in poor process suitability in some cases. The ratio (B)/(A) is preferably 0.23 or more, and more preferably 0.25 or more.

[Component (C) Fluxing Agent]

The flux sheet of the present invention can contain a fluxing agent as necessary.

The fluxing agent has an action to reduce or remove an oxide on a metal surface for improving solderability. By reducing or removing the oxide on the metal surface, wettability is improved, and the self-alignment effect that corrects the positional displacement between the electrode of the device and the electrode of the wiring board can be provided or improved.

The fluxing agent in the present invention is one other than the component (A) or the component (B).

In the present invention, "contain a fluxing agent as necessary" means that the component (C) is contained when the flux activity is provided to the flux sheet in a case where the component (A) or the component (B) does not have the flux activity, or it is necessary to further strongly develop the flux activity even in a case where the component (A) or the component (B) has the flux activity.

For example, when a vinylpyrrolidone homopolymer is used as the component (A), the vinylpyrrolidone homopolymer does not have the flux activity. Therefore, when the component (B) also does not have the flux activity, the flux sheet needs to contain the component (C) fluxing agent.

Similarly, for example, when an acrylic copolymer including an acid group is used as the component (A), the oxide film of the metal is not sufficiently removed due to the small amount of the acid group in some cases. In this case, to sufficiently develop the flux activity, the component (C) fluxing agent needs to be contained. Accordingly, when the acrylic copolymer with the small amount of the acid group is used as the component (A), the flux sheet of the present invention contains the (C) fluxing agent.

Examples of the (C) fluxing agent can include an acid compound, a basic compound, a compound having an alcoholic hydroxyl group, aldehydes, carboxylic acid salt, and amine salt.

The fluxing agent is preferably one without a metallic element because the flux sheet of the present invention

is used for the substrate. Therefore, an organic acid (carboxylic acids, phenols, and the like) is preferable as the acid compound, and imidazoles and amines are preferable as the basic compound.

Examples of carboxylic acids used as the fluxing agent can include salicylic acid, benzoic acid, m-dihydroxybenzoic acid, pyromellitic acid, sebacic acid, abitienic acid, succinic acid, glutaric acid, adipic acid, or maleic acid. Among the compounds containing carboxylic acid, glutaric acid is especially preferable.

Examples of imidazoles used as the fluxing agent include imidazole, 2-methyl imidazole, 2-ethyl-4-methyl imidazole, and 1-benzyl-2-phenyl imidazole.

Examples of aminos used as the fluxing agent can include dodecylamine.

Examples of aldehyde can include aldoses (glutaraldehyde, perillaldehyde, glyceraldehyde, and the like).

Examples of amine salt can include (organic) amine hydrohalide, such as diphenyl guanidine hydrobromide and cyclohexylamine hydrobromide. They are referred to as an activator in some cases.

In the present invention, for the component (C) fluxing agent, a fluxing agent that does not hinder the effect of the present invention by the reaction or the interaction of the component (A) and the component (B) is selected and used.

Since the residue of the flux sheet of the present invention is removed by water washing, the component (C) fluxing agent is preferably water-soluble.

[Other Components]

The flux sheet of the present invention can contain water by 10 mass% or less based on the flux sheet in a range not hindering the effect of the present invention.

The flux sheet of the present invention can contain other components in a range not hindering the effect of the present invention.

Examples of the other components include a lubricant, an antioxidant, an antistatic agent, a surfactant, and solder particles.

The flux sheet of the present invention preferably does not contain a thermosetting resin. This is because the thermosetting resin hardens in the reflow step, and fails to be removed by water washing or the like in some cases.

[Method for Manufacturing Flux Sheet]

The flux sheet of the present invention can be manufactured using a publicly known method for manufacturing an adhesive flux sheet.

For example, first, it can be manufactured by forming a layer using a composition containing components constituting the flux sheet of the present invention on a prepared stripping sheet.

The substrate of the stripping sheet is not specifically limited insofar as the composition for forming the sheet of the present invention can be stripped. Examples of the substrate of the stripping sheet can include polyester, polyolefin, and polyamide.

Examples of polyester can include polyethylene terephthalate, polytetramethylene terephthalate, polyethylene naphthalate, and polytetramethylene terephthalate.

Examples of polyolefin can include linear low-density polyethylene, low-density polyethylene, medium-density polyethylene, and polypropylene.

Examples of polyamide can include polycaprolactam, polyhexamethylene adipamide, polytetramethylene adipamide, polyhexamethylene isophthalamide, polyhexamethylene sebacamide, polyhexamethylene dodecamide, polyhexamethylene terephthalamide, polynonamethylene terephthalamide, poly(decamethylene terephthalamide), polyundecane lactam, polydodecane lactam, and poly(meta-xylylene adipamide).

A publicly known release process may be performed on at least one surface of the stripping sheet.

The layer using the composition containing components constituting the flux sheet of the present invention may be formed on one surface or both surfaces of the stripping sheet.

A method for providing the layer using the composition for the flux sheet of the present invention is not specifically limited, and a publicly known method can be used.

For example, it can be manufactured by dissolving or dispersing a composition containing all or a part of the components constituting the flux sheet in a solvent, and applying it over a stripping sheet.

Examples of the solvent can include water, an organic solvent, and a mixture of water and the organic solvent. Examples of the organic solvent can include methanol, ethanol, 1-propanol, 2-propanol, 1-butanol, 2-butanol, 2-methyl 1-propanol, 2-methy 2-propanol, 1-pentanol, 2-pentanol, 3-pentanol, 2-methyl 1-butanol, 2-methy 2-butanol, 3-methy 1-butanol, 3-methy 2-butanol, and 2,2-dimethyl 1-propanol.

The application method is not specifically limited insofar as the layer formed by using the composition for the flux sheet of the present invention can be formed in a uniform thickness. Examples of the method for forming the layer in uniform thickness can include spin coating, blade coating, slit coating, and slot-die coating.

When the composition containing a part of the components constituting the flux sheet is used, for example, after the layer is formed, a liquid component (for example, component (B) or component (C)) may be impregnated or substituted before drying or after drying the flux sheet.
The drying temperature is from 50°C to 120°C, and preferably from 60°C to 100°C.

[Method for Using Flux Sheet]

The flux sheet of the present invention can be used, for example, for manufacturing an electronic component including steps below. The following explanation for the method for using the flux sheet can be replaced with the explanation for the method for manufacturing an electronic component of the present invention.

(1) a step of locating the flux sheet of the present invention on an electrode surface side of a wiring board and performing bonding,
(2) a step of transferring a semiconductor device on the flux sheet of the present invention,
(3) a reflow soldering step of physically and electrically joining the semiconductor device on the wiring board,
(4) a washing step of removing a residue of the flux sheet, and
(5) a step of drying the wiring board

<(1) Bonding Step>

In the step of locating the flux sheet of the present invention on an electrode surface side of a wiring board and performing bonding, the flux sheet of the present invention formed on a stripping sheet is bonded to the wiring board. When the flux sheet of the present invention includes a peel-off sheet, the stripping sheet is peeled off.
Before bonding the flux sheet of the present invention, the electrode surface of the wiring board may be washed. The washing can be performed using an organic solvent, an acidic aqueous solution, a basic aqueous solution, or the like.
The wiring board is not specifically limited insofar as it is a substrate with a wiring, and examples can include TFT backplane as a glass substrate, FR-4 as a glass epoxy substrate, a ceramic substrate, and a silicon wafer.

<(2) Transfer Step>

The transfer step is a step of determining the position of the semiconductor device on the wiring board, and transferring the semiconductor device from a substrate on which the semiconductor device is formed, or a substrate temporarily holding the semiconductor device, which are a transfer source, to the top of the flux sheet of the present invention as a transfer destination.
Hereinafter, a substrate on which the semiconductor device has been formed is referred to as a "device formation substrate" in other words.

· Contactless Transfer Step

As one configuration of the transfer step, a contactless transfer step will be described as an example with reference to FIG. 1. The transfer step using the flux sheet of the present invention is not limited to the exemplified configuration. The drawing is partially enlarged or reduced for ease of understanding.

(i) A transfer destination substrate 1A manufactured in the above-described (1) bonding step illustrated in FIG. 1(a) is disposed such that a surface in the opposite side of a surface of a flux sheet 11A for semiconductor transfer of the present invention bonded with a wiring board 12A is opposed to a surface with semiconductor devices 21A of a transfer source substrate 2A with a void.
Here, the transfer source substrate 2A illustrated in FIG. 1(a) includes the semiconductor devices 21A that are formed on one surface of a device temporarily holding substrate 23A and held by a sticking layer 22A.
(ii) As illustrated in FIG. 1(b), an energy beam 3 (laser or the like) is irradiated on desired one or two or more positions of the semiconductor devices from a surface in the opposite side of the surface on which the semiconductor devices 21A are formed of the transfer source substrate 2A. By the irradiation with the energy beam 3 (laser or the like), as illustrated in FIG. 1(c), the semiconductor devices 21A are separated from the transfer source substrate 2A, and the separated semiconductor devices 21A are adhered to the flux sheet 11A of the transfer destination, thus performing the transferring.
(iii) Then, as illustrated in FIG. 1(d), a transfer source substrate 2B including a device temporarily holding substrate 23B that holds semiconductor devices 21B different from the semiconductor devices 21A is moved to a desired position with respect to the transfer destination substrate 1A. After the moving, the above-described (ii) is repeated

as illustrated in FIGS. 1(e) and 1(f).

(iv) By repeatedly performing the above-described (ii) and (iii), and as necessary (i), the semiconductor devices are transferred and disposed at all the desired positions of the transfer destination substrate 1A (not illustrated).

The wiring board 12A of the transfer destination substrate 1A is a substrate including one or more electrodes. For improving wettability with solder, various kinds of surface processes (for example, forming a UBM layer, a Surface finish layer, or the like) may be performed on the electrode surface.

The device temporarily holding substrates 23A and 23B of the transfer source substrates 2A and 2B may be, for example, any of a sapphire substrate, a quartz glass, a glass, and a plastic. The separation between the device temporarily holding substrate 23A and the semiconductor devices 21A and the separation between the device temporarily holding substrate 23B and the semiconductor devices 21B are caused by, for example, decomposition (and foaming), aggregation, or softening/melting of the components constituting sticking layers 22A and 22B by the irradiation with the energy beam 3 (laser or the like).

Therefore, for the efficient absorption of the energy of the energy beam (laser or the like) in the sticking layers 22A and 22B, the device temporarily holding substrates 23A and 23B are preferably those transmitting the energy beam or those low in absorption.

The components constituting the sticking layers 22A and 22B of the transfer source substrates 2A and 2B contain a sticking agent component. Examples of the sticking agent component include silicone, an acrylic-based polymer, a polyvinyl alcohol-based polymer, and a vinylpyrrolidone-based polymer. The components constituting the sticking layers 22A and 22B may contain a component that forms foam or a cross-linking component that promotes aggregation by the energy beam (laser).

Examples of the energy beam include a laser. Examples of the laser include an excimer laser and a higher harmonic YAG laser.

· Contact Transfer Step

Next, as another configuration of the transfer step, a contact transfer step will be described with reference to FIG. 2.

This configuration is similar to the contactless transfer step except that transfer is performed by contacting the semiconductor devices of the device temporarily holding substrate with the flux sheet of the present invention of the substrate. Therefore, the description will be given of (i) to (iv) below, and the contents common in the transfer step other than those will be omitted.

(i) Semiconductor devices 21C of a transfer source substrate 2C are brought into contact with a flux sheet 11B of a transfer destination substrate 1B illustrated in FIG. 2(b).

(ii) As illustrated in FIG. 2(c), an energy beam 3 (laser or the like) is irradiated on desired one or two or more positions of the semiconductor devices from a surface in the opposite side of the surface on which the semiconductor devices 21C are formed of the transfer source substrate 2C. By the irradiation with the energy beam 3 (laser or the like), as illustrated in FIG. 2(d), the semiconductor devices 21C are separated from the transfer source substrate 2C of the transfer source, and the separated semiconductor devices 21C are adhered to the flux sheet 11B of the transfer destination, thus performing the transferring.

(iii) After transferring the separated semiconductor devices 21C, as illustrated in FIG. 2(e), a transfer source substrate 2D including a device temporarily holding substrate 23D that holds semiconductor devices 21D different from the semiconductor devices 21C is moved to a desired position, and the semiconductor devices 21D of the transfer source substrate 2D are brought into contact with the flux sheet 11B. After the contact, the above-described (ii) is repeated as illustrated in FIGS. 2(c) and 2(d).

(iv) By repeatedly performing the above-described (ii) and (iii), and as necessary (i), the semiconductor devices are transferred and disposed at all the desired positions of the transfer destination substrate 1B (not illustrated).

· Modification of Configuration in Transfer Step

The configuration in the transfer step is not limited to the above-described configuration. The modification, improvement, and the like within the range in which the object of the present invention is achievable can be included.

All the semiconductor devices formed on the device temporarily holding substrate in the above-described contactless transfer step or contact transfer step may be irradiated with the energy beam (laser), thereby collectively transferring the semiconductor devices.

In (iii) of the above-described contactless transfer step or contact transfer step, the transfer destination substrate 1A and 1B may be moved instead of the device temporarily holding substrate (23B and 23D) or together with the device

temporarily holding substrate (23B or 23D).

Furthermore, a device formation substrate can be used instead of the transfer source substrates (2A, 2B, 2C, and 2D) or together with the transfer source substrates (2A, 2B, 2C, and 2D) in the above-described contactless transfer or contact transfer.

Examples of the device formation substrate include one in which a stacked body including various layers, such as a conductive layer, is formed on a sapphire substrate, a semiconductor crystal is grown or the like in the stacked body, and thus a light-emitting diode is formed. When the laser is irradiated on the crystal through the sapphire substrate, a surface of the layer at an interface with the sapphire substrate decomposes, and thus the light-emitting diode can be separated.

<(3) Reflow Soldering Step>

In the reflow soldering step of electrically joining the devices on the wiring board, the flux sheet of the present invention softens and melts. By the softening and melting of the flux sheet of the present invention between the devices and the wiring board, the bumps of the devices and the electrodes of the wiring board are physically brought into contact, and joined by the melted solder. Since the flux sheet of the present invention contains a component having a fluxing action, a metal oxide at the terminal is reduced or removed, and the poor joint by the solder is suppressed.

While the maximum temperature of the reflow soldering step is selected depending on the type of the solder and the heat resistance of the semiconductor, the maximum temperature of the reflow soldering step is, for example, preferably 150°C or more, more preferably 160°C or more, and further preferably 170°C or more.

150°C or more is preferable for avoiding the poor connection due to the lack of wetting of the solder.

The temperature of the reflow soldering step is preferably 260°C or less, more preferably 240°C or less, and further preferably 230°C or less.

260°C or less avoids distortion or the like, and it is preferable for the satisfactory solderability.

<(4) Washing Step>

The flux sheet of the present invention remains after the reflow step. Therefore, the flux sheet residues are removed by washing.

For the washing, while only a water from which ions are removed (ultrapure water, ion exchanged water, distilled water, or the like) may be used, or a mixture of a water-soluble organic solvent and water may be used, only the water from which ions are removed is preferable from the aspect of the low environmental load and the availability. Hereinafter, the water from which ions are removed and the mixture of a water-soluble organic solvent and water are referred to as "water or the like" in other words. An additive that hydrolyzes a water-soluble sticking agent may be added to the water or the like. Examples of a hydrolase can include amylase, glucoamylase, prunase, cellulase, and protease. When the hydrolase is used, the washing is preferably performed at optimal pH and temperature region in which a high enzyme activity is developed, and depending on the enzyme, by adding an additive, such as $Ca^{2+}$, the enzyme activity can be more increased.

Examples of the water-soluble organic solvent can include alcohol and ketone, and alcohol is preferable. When the water-soluble organic solvent is used, one may be used alone, and two or more may be used in combination. Examples of alcohol include methanol, ethanol, n-propanol, and n-butanol, and examples of ketone include acetone and methyl ethyl ketone. A mixture of the water from which ions are removed and a water-soluble organic solvent may be used, and while the mixing ratio is not specifically limited, from the aspect of reducing the environmental load, it is preferable that the ratio of the water-soluble organic solvent is low. The water or the like may be used by adding commercially available flux cleaning agent. While the flux cleaning agent is not specifically limited, one mixed with the water or the like is preferable. The flux cleaning agent may be directly used without dilution with the water or the like. The additive amount of the fluxing cleaning agent to the water or the like is preferably 1 mass% or more, and further preferably 5 mass% or more from the aspect of the improvement of washability. From the aspect of the cost, 30 mass% or less is preferable, and 20 mass% or less is further preferable.

As a commercial product of the flux cleaning agent, PINE ALPHA ST-231 (manufactured by ARAKAWA CHEMICAL INDUSTRIES, LTD.) or the like can be used.

In the washing step, the temperature of the water or the like to be used is selected based on the solubilities of the component (A) and the component (B). For example, the temperature of the water or the like used in water washing is preferably 10°C or more, more preferably 20°C or more, and further preferably 30°C or more.

With 10°C or more, the residue after the washing tends to be eliminated or reduced, and it is preferable.

The temperature of the water or the like used in the water washing is preferably 80°C or less, more preferably 70°C or less, and further preferably 60°C or less.

With 80°C or less, the energy consumption is small, and it is preferable because of the low environmental load.

When the hydrolase is used, since enzymes each have an optimal temperature range for high activity, washing at the above-described temperature is preferable.

In the flux sheet using a vinyl alcohol-based polymer with the oxyalkylene structure for the component (A), since the water solubility is excellent, the washing can be performed with the water or the like at lower temperature compared with a polymer including only the vinyl alcohol repeating unit and the native repeating unit.

<(5) Drying Step>

The drying step of the wiring board may be a method (spin dryer) that performs dehydration with centrifugal force or a method that performs drying after the washing with an organic solvent using the organic solvent (isopropanol or the like) having high vaporizability and water miscibility.

The drying temperature can be appropriately designed at a boiling point of the solvent or the like.

[Examples]

While the following specifically describes the present invention using examples, the technical scope of the present invention is not limited by these examples.

The measurement method and the evaluation method used in the present invention are as follows.

Measurement method

(1) Saponification Degree of Polyvinyl Alcohol-Based Polymer

[1] The saponification degree was obtained based on $^1$H-NMR when the third repeating unit (oxyalkylene structure or the like) was included, and based on JIS K6726 when the repeating unit was not included.

(2) Weight Average Molecular Weight of Polymer

Gel permeation chromatography (GPC method) was used.

Detector: RI
Eluent: tetrahydrofuran (THF)
Standard Substance: polystyrene

(3) Content Rate of Oxyalkylene Group

As the content rate of oxyalkylene group, a value was obtained by a formula below using $^1$H NMR.

$$\text{Oxyalkylene content rate (\%)} = [\text{number of repeating units including oxyalkylene group}]/[\text{number of all the repeating units}] \times 100$$

Here, the number of all the repeating units means a sum of the number of the repeating units including the oxyalkylene group, the number of the vinyl alcohol repeating units, and the number of the repeating units other than both repeating units.

(4) Composition of Flux Sheet

In the flux sheets in Table 4 and Table 5, the moisture amount contained in the flux sheet was measured by Karl Fischer's method. The composition was calculated assuming that the (A) water-soluble sticking agent, the (B) water-soluble plasticizer, or the (C) fluxing agent was not removed from the system due to vaporization or the like in the drying step of the manufacture of the flux sheet, and the solvents other than water were all removed from the system.

(5) Measurement of Viscosity

The viscosity was measured for samples at 25°C using a rotational viscometer (manufactured by Toki Sangyo Co., Ltd, TVE-25H type viscometer). The rotation speed is 1 rpm (polyglycerin), 50 rpm (glycerin, PEG600, PPG3000), 100 rpm (diethylene glycol, ethylene glycol, propylene glycol, PEG400, diethylene glycol monomethyl ether).

Evaluation Method

(1) Transferability Evaluation Method

A glass plate (manufactured by Matsunami Glass Ind., Ltd., product name: micro slide glass S111, thickness from 0.8 to 1.0 mm) was pressed against the flux sheet (thickness 5 μm) at ordinary temperature (25°C) using a roller, and then, a polyethylene terephthalate film was peeled off. A solder ball (SAC305, diameter 0.20 mm) was dropped on the glass plate on which the flux sheet was attached from a position at a height of 50 cm.

The solder ball having an alloy composition of 96.5 mass% of Sn, 3.0 mass% of Ag, and 0.5 mass% of Cu (Sn-3.0Ag-0.5Cu, hereinafter referred to as "SAC305") was used.

The moving image of the falling point was recorded by a digital microscope, and rebounded or not and the positional displacement from the falling point were observed.

A: not rebounded and positional displacement within 10 μm
B: not rebounded and positional displacement exceeding 10 μm and within 50 μm
C: not rebounded and positional displacement exceeding 50 μm, or rebounded

(2) Flux Activity Evaluation Method

The flux sheet of the present invention was attached to an FR-4 substrate (glass epoxy substrate) in which a Surface finish layer (Cu/Ni/Au (Ni layer thickness 0.3 μm, Au layer thickness 0.03 μm)) was formed on a surface of an electrode formed of copper similarly to the above-described (1) Transferability Evaluation Method. A solder ball was mounted on a pad of the substrate via the flux sheet. The reflow was performed under nitrogen atmosphere under recommend conditions (illustrated in FIG. 3) of JEDEC.

As the solder ball, SAC305 having the diameter of 760 μm was used.

A shear test of the ball was performed five times with a die shear tester (manufactured by Nordson Advanced Technology, product name: Dage series 4000), and the fracture surface was observed.

A: cohesive failure in all of the five times
B: cohesive failure in two to four times, and interfacial failure in the others
C: cohesive failure in one time and interfacial failure in the others, or interfacial failure in all of the five times

(3) Washability Evaluation Method

After performing the reflow according to the above-described evaluation procedure of the flux activity, stirring (200 rpm) was performed for 10 minutes in an ion exchanged water at ordinary temperature, a flux cleaning fluid (manufactured by ARAKAWA CHEMICAL INDUSTRIES, LTD., PINE ALPHA ST-231 was diluted with an ion exchanged water and used by 20 mass%) at 50°C, an enzyme cleaning fluid 1 (Spitase HK/R manufactured by Nagase ChemteX Corporation was diluted with an ion exchanged water to obtain by 1 mass%, and used by adding calcium hydroxide so as to obtain by 3 mM) at 90°C, or an enzyme cleaning fluid 2 (Cellulizer ACE manufactured by Nagase ChemteX Corporation was used by 1 mass%) at 50°C. After the washing, the substrate surface was observed with a microscope.

A: residue cannot be confirmed
B: a small amount (less than 10% of substrate area) of residue can be confirmed at solder end portion and the like
C: residue can be confirmed over the whole substrate surface (10% or more of the substrate area)

(4) Process Suitability

The suitability to the process in which the transfer step, the reflow step, and the washing step were sequentially performed was evaluated.

A: when the transferability evaluation is A, the flux activity evaluation is A, and in the washability evaluation, one or

more is the evaluation A among the ion exchanged water, the flux cleaning agent, the enzyme cleaning fluid 1, and the enzyme cleaning fluid 2, or when the transferability evaluation is B, the flux activity evaluation is A, and in the washability evaluation, one or more is the evaluation A among the ion exchanged water, the flux cleaning agent, the enzyme cleaning fluid 1, and the enzyme cleaning fluid 2.

B: when the transferability evaluation is A, the flux activity evaluation is B, and in the washability evaluation, one or more is the evaluation A among the ion exchanged water, the flux cleaning agent, the enzyme cleaning fluid 1, and the enzyme cleaning fluid 2, or when the transferability evaluation is A, the flux activity evaluation is A, and in the washability evaluation, no one is the evaluation A and one or more is the evaluation B among the ion exchanged water, the flux cleaning agent, the enzyme cleaning fluid 1, and the enzyme cleaning fluid 2.

C: evaluation other than the above-described A or B.

Table 1 indicates the evaluation criteria of the process suitability.

[Table 1]

| Process Suitabliy | Transferability | Flux Activity | Washability | | | |
|---|---|---|---|---|---|---|
| | | | Ion Exchanged Water | Flux Cleaning Agent | Enzyme Cleaning Fluid 1 | Enzyme Cleaning Fluid 2 |
| A | A | A | Evaluation A is given to any one or more of four cleaning agents | | | |
| | B | A | | | | |
| B | A | B | | | | |
| | A | A | Evaluation A is given to none, and evaluation B is given to any one or more offour cleaning agents | | | |
| C | Evaluation other than above | | | | | |

Table 2 and Table 3 indicate the components and the proportions of solutions used for the manufacture of the flux sheets of examples and comparative examples. Table 4 and Table 5 indicate the ratios of the respective components of the flux sheets based on the mass and the evaluation results.

[Example 1]

(Manufacture of Polymer)

An air in a reactor including a stirrer, a reflux condenser tube, a nitrogen inlet tube, a thermometer, and a pressure gauge was replaced by nitrogen. For methanol and a vinyl acetate monomer, dissolved oxygen was replaced by blowing nitrogen gas thereinto.

100 pts.mass of methanol and 100 pts.mass of a vinyl acetate monomer (manufactured by Mitsubishi Chemical Corporation, product name: vinyl acetate monomer (VAM)) were put into the reactor, and stirred and heated.

At the point when the solution inside the reaction container became 60°C, a solution in which 0.10 pts.mass of azobisisobutyronitrile was dissolved in 50 pts.mass of methanol was added, and polymerized at 60°C for three hours. The polymerization was cooled and stopped. The polymerization solution was added to the ion exchanged water, and polyvinyl acetate was deposited. The polyvinyl acetate was recovered by filtration, purified by washing with the ion exchanged water, and then dried under vacuum at 50°C for 24 hours. The obtained polyvinyl acetate was 45 pts.mass.

100 pts.mass of the obtained polyvinyl acetate was dissolved in 286 pts.mass of methanol, an alkaline solution in which 1.4 g of sodium hydroxide was dissolved in 12.6 g of methanol was added to the solution and reacted at 40°C for 30 minutes, thus saponifying it. 60 mass% of an acetic acid aqueous solution was added by 3.5 g, thereby stopping the saponification reaction.

After the saponification, the deposited polymer was recovered by filtration, purified by washing with methanol, and then dried under vacuum at 60°C for 12 hours.

After the drying, 55 pts.mass of polyvinyl alcohol was obtained. The saponification degree was 51%, the weight average molecular weight Mw was 11000, and the molecular weight distribution Mw/Mn was 2.1.

(Manufacture of Flux Sheet)

100 pts.mass of the polyvinyl alcohol manufactured in the above-described polymerization example, 150 pts.mass of diethylene glycol, and 5 pts.mass of salicylic acid were dissolved in 300 pts.mass of a water/methanol mixed solution (mass ratio 1/1), thus obtaining a polyvinyl alcohol solution.

The polyvinyl alcohol solution was applied over a polyethylene terephthalate film (manufactured by LINTEC Corporation, 6502) on which a release process was performed using an applicator.

Drying was performed at 80°C, thus obtaining a flux sheet having a film thickness of 5 μm.

[Example 2]

(Manufacture of Polymer)

Polymerization was similarly performed except that 77 pts.mass of vinyl acetate monomer and 23 pts.mass of polyoxyethylene monoallyl ether (average number of added moles of ethylene oxide was 8, manufactured by NOF CORPORATION, product name: UNIOX PKA-5002) were used instead of 100 pts.mass of vinyl acetate monomer in Example 1.

After the drying, 55 pts.mass of oxyalkylene group-containing polyvinyl alcohol-based copolymer was obtained.

The saponification degree was 42%, the weight average molecular weight Mw was 15000, and the molecular weight distribution Mw/Mn was 2.2. The oxyalkylene group content rate was 3 mol%.

(Manufacture of Flux Sheet)

A flux sheet was similarly obtained except that an oxyalkylene group-containing polyvinyl alcohol-based copolymer solution in which 100 pts.mass of the oxyalkylene group-containing polyvinyl alcohol-based copolymer manufactured in the above-described polymerization example, 100 pts.mass of glycerin, and 7 pts.mass of adipic acid were dissolved in 300 pts.mass of water was used instead of the polyvinyl alcohol solution in Example 1.

[Example 3]

(Manufacture of Polymer)

Polymerization was similarly performed except that 44 pts.mass of vinyl acetate monomer and 56 pts.mass of methacrylic acid ester of ethylene oxide monomethyl ether (average number of added moles of ethylene oxide was 23, manufactured by SHIN-NAKAMURA CHEMICAL Co., Ltd., product name: AM-230G) were used instead of 100 pts.mass of vinyl acetate monomer in Example 1.

After the drying, 45 pts.mass of oxyalkylene group-containing vinyl alcohol-based copolymer was obtained.

The saponification degree was 35%, the weight average molecular weight Mw was 12000, and the molecular weight distribution Mw/Mn was 2.8. The oxyalkylene group content rate was 5 mol%.

(Manufacture of Flux Sheet)

A flux sheet was similarly obtained except that an oxyalkylene group-containing polyvinyl alcohol-based copolymer solution in which 100 pts.mass of the oxyalkylene group-containing polyvinyl alcohol-based copolymer manufactured in the above-described polymerization example, 80 pts.mass of ethylene glycol, and 5 pts.mass of succinic acid were dissolved in 300 pts.mass of ion exchanged water was used instead of the polyvinyl alcohol solution in Example 1.

[Example 4]

(Manufacture of Flux Sheet)

A flux sheet was similarly obtained except that a polyvinyl alcohol solution in which 100 pts.mass of polyvinyl alcohol (manufactured by Mitsubishi Chemical Corporation, GOHSENOL (registered trademark) GM-14R, saponification degree 88%), 200 pts.mass of glycerin, and 5 pts.mass of adipic acid were dissolved in 200 pts.mass of ion exchanged water was used instead of the polyvinyl alcohol solution in Example 1. Note that when the polyvinyl alcohol (manufactured by Mitsubishi Chemical Corporation, GOHSENOL (registered trademark) GM-14R, saponification degree 88%) is dissolved in an ion exchanged water at ordinary temperature, since undissolved residue is easily generated, 100 pts.mass of the polyvinyl alcohol and 200 pts.mass of the ion exchanged water were dissolved at 90°C for 30 minutes in advance,

and then the other components were added.

[Example 5]

(Manufacture of Flux Sheet)

A flux sheet was similarly obtained except that a polyvinyl alcohol solution in which 100 pts.mass of polyvinyl alcohol (manufactured by Mitsubishi Chemical Corporation, GOHSENOL (registered trademark) GL-03, saponification degree 88%), 200 pts.mass of propylene glycol (propane-1,2-diol), 100 pts.mass of diethylene glycol monomethyl ether, and 3 pts.mass of maleic acid were dissolved in 200 pts.mass of ion exchanged water was used instead of the polyvinyl alcohol solution in Example 1. Note that when the polyvinyl alcohol (manufactured by Mitsubishi Chemical Corporation, GOHSENOL (registered trademark) GL-03, saponification degree 88%) is dissolved in an ion exchanged water at ordinary temperature, since undissolved residue is easily generated, 100 pts.mass of the polyvinyl alcohol and 200 pts.mass of the ion exchanged water were dissolved at 90°C for 30 minutes in advance, and then the other components were added.

[Example 6]

(Manufacture of Flux Sheet)

A flux sheet was similarly obtained except that an oxyethylene group-containing vinyl alcohol-based polymer solution in which 625 pts.mass of oxyethylene group-containing vinyl alcohol-based polymer aqueous solution (manufactured by Mitsubishi Chemical Corporation, GOHSENOL (registered trademark) LW-100, solid content 40 mass%, saponification degree 40%), 100 pts.mass of glycerin, and 7.5 pts.mass of adipic acid were dissolved in 100 pts.mass of ion exchanged water was used instead of the polyvinyl alcohol solution in Example 1.

[Example 7]

(Manufacture of Flux Sheet)

A flux sheet was similarly obtained except that an oxyethylene group-containing vinyl alcohol-based polymer solution in which 625 pts.mass of oxyethylene group-containing vinyl alcohol-based polymer aqueous solution (manufactured by Mitsubishi Chemical Corporation, GOHSENOL (registered trademark) LW-200, solid content 40 mass%, saponification degree 50%), 150 pts.mass of glycerin, and 8 pts.mass of salicylic acid were dissolved in 150 pts.mass of ion exchanged water was used instead of the polyvinyl alcohol solution in Example 1.

[Example 8]

(Manufacture of Flux Sheet)

A flux sheet was similarly obtained except that a polyvinylpyrrolidone solution in which 100 pts.mass of polyvinylpyrrolidone (DKS Co. Ltd., K-30), 50 pts.mass of ethylene glycol, and 10 pts.mass of glutaric acid were dissolved in 100 pts.mass of ion exchanged water was used instead of the polyvinyl alcohol solution in Example 1.

[Example 9]

(Manufacture of Flux Sheet)

A flux sheet was similarly obtained except that a carboxymethyl cellulose solution in which 100 pts.mass of carboxymethyl cellulose (Daicel Miraizu Ltd., part number 1330), 250 pts.mass of glycerin, and 5 pts.mass of adipic acid were dissolved in 1000 pts.mass of ion exchanged water was used instead of the polyvinyl alcohol solution in Example 1.
The degree of etherification of the used carboxymethyl cellulose was 1.2.
Here, the degree of etherification indicates the average degree of substitution of three hydroxyl groups present in one glucose of cellulose by an etherifying agent.

[Example 10]

(Manufacture of Flux Sheet)

A flux sheet was similarly obtained except that a hydroxyethyl cellulose solution in which 100 pts.mass of hydroxyethyl cellulose (Daicel Miraizu Ltd., SP500), 150 pts.mass of polyethylene glycol (manufactured by NOF CORPORATION, PEG#400), and 3 pts.mass of salicylic acid were dissolved in 2000 pts.mass of ion exchanged water was used instead of the polyvinyl alcohol solution in Example 1.

[Example 11]

(Manufacture of Flux Sheet)

A flux sheet was similarly obtained except that a pullulan solution in which 100 pts.mass of pullulan (manufactured by HAYASHIBARA CO., LTD.), 200 pts.mass of glycerin, and 24 pts.mass of glutaric acid were dissolved in 1000 pts.mass of ion exchanged water was used instead of the polyvinyl alcohol solution in Example 1.

[Example 12]

(Manufacture of Flux Sheet)

A flux sheet was similarly obtained except that a polyvinylpyrrolidone solution in which 100 pts.mass of polyvinylpyrrolidone (NIPPON SHOKUBAI CO., LTD., K-85N), 200 pts.mass of polyethylene glycol (FUJIFILM Wako Pure Chemical Corporation, PEG#600), and 24 pts.mass of glutaric acid were dissolved in 800 pts.mass of ion exchanged water was used instead of the polyvinyl alcohol solution in Example 1.

[Example 13]

(Manufacture of Flux Sheet)

A flux sheet was similarly obtained except that an oxyethylene group-containing vinyl alcohol-based polymer solution in which 625 pts.mass of oxyethylene group-containing vinyl alcohol-based polymer aqueous solution (manufactured by Mitsubishi Chemical Corporation, GOHSENOL (registered trademark) LW-100, solid content 40 mass%, saponification degree 40%), 62.5 pts.mass of glycerin, and 10 pts.mass of glutaric acid were dissolved in 100 pts.mass of ion exchanged water was used instead of the polyvinyl alcohol solution in Example 1.

[Example 14]

(Manufacture of Flux Sheet)

A flux sheet was similarly obtained except that an oxyethylene group-containing vinyl alcohol-based polymer solution in which 625 pts.mass of oxyethylene group-containing vinyl alcohol-based polymer aqueous solution (manufactured by Mitsubishi Chemical Corporation, GOHSENOL (registered trademark) LW-100, solid content 40 mass%, saponification degree 40%), 75 pts.mass of glycerin, and 10 pts.mass of glutaric acid were dissolved in 100 pts.mass of ion exchanged water was used instead of the polyvinyl alcohol solution in Example 1.

[Example 15]

(Manufacture of Flux Sheet)

A flux sheet was similarly obtained except that a polyvinylpyrrolidone solution in which 100 pts.mass of polyvinylpyrrolidone (NIPPON SHOKUBAI CO., LTD., K-85N), 200 pts.mass of polypropylene glycol (FUJIFILM Wako Pure Chemical Corporation, PPG#3000), and 24 pts.mass of glutaric acid were dissolved in 800 pts.mass of ethanol was used instead of the polyvinyl alcohol solution in Example 1.

[Example 16]

(Manufacture of Flux Sheet)

A flux sheet was similarly obtained except that an oxyethylene group-containing vinyl alcohol-based polymer solution in which 625 pts.mass of oxyethylene group-containing vinyl alcohol-based polymer aqueous solution (manufactured by Mitsubishi Chemical Corporation, GOHSENOL (registered trademark) LW-100, solid content 40 mass%, saponification degree 40%), 200 pts.mass of polyglycerin (manufactured by Daicel Corporation, PLG 20PW), and 10 pts.mass of glutaric acid were dissolved in 100 pts.mass of ion exchanged water was used instead of the polyvinyl alcohol solution in Example 1.

[Comparative Example 1]

A flux sheet was similarly obtained except that an oxyethylene group-containing vinyl alcohol-based polymer solution in which 250 pts.mass of oxyethylene group-containing vinyl alcohol-based polymer (manufactured by Mitsubishi Chemical Corporation, GOHSENOL (registered trademark) LW-100, saponification degree 40%), and 8.5 pts.mass of adipic acid were dissolved in 375 pts.mass of ion exchanged water was used instead of the polyvinyl alcohol solution in Example 1.

[Comparative Example 2]

(Manufacture of Flux Sheet)

A flux sheet was similarly obtained except that a polyvinyl alcohol solution in which 100 pts.mass of polyvinyl alcohol (manufactured by Mitsubishi Chemical Corporation, GOHSENOL (registered trademark) GM-14R), 18 pts.mass of ethylene glycol, and 5 pts.mass of glutaric acid were dissolved in 200 pts.mass of ion exchanged water was used instead of the polyvinyl alcohol solution in Example 1. Note that when the polyvinyl alcohol (manufactured by Mitsubishi Chemical Corporation, GOHSENOL (registered trademark) GM-14R, saponification degree 88%) is dissolved in an ion exchanged water at ordinary temperature, since undissolved residue is easily generated, 100 pts.mass of the polyvinyl alcohol and 200 pts.mass of the ion exchanged water were dissolved at 90°C for 30 minutes in advance, and then the other components were added.

[Comparative Example 3]

(Manufacture of Flux Sheet)

A flux sheet was similarly obtained except that a polyvinylpyrrolidone solution in which 100 pts.mass of polyvinylpyrrolidone (NIPPON SHOKUBAI CO., LTD., K-85N), 200 pts.mass of polyethylene glycol (FUJIFILM Wako Pure Chemical Corporation, PEG#1000), and 24 pts.mass of glutaric acid were dissolved in 800 pts.mass of ion exchanged water was used instead of the polyvinyl alcohol solution in Example 1.

Since the sticking force was not provided at all, and the transfer from the film to another test piece was impossible, the evaluation is poor in the table.

[Table 2]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| (A) Water-Soluble Sticking Agent (pts.mass) | PVA | 100 | 100 | 100 | 100 | 100 | 250 | 250 | | | | |
| | PVP | | | | | | | | 100 | | | |
| | CMC | | | | | | | | | 100 | | |
| | SP500 | | | | | | | | | | 100 | |
| | Pullulan | | | | | | | | | | | 100 |

(continued)

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| (B) Water-Soluble Plasticizer (pts.mass) | Water-Soluble Plasticizer 1 (Mw < 500) | Viscosity (mPa.s) | | | | | | | | | | | |
| | Diethylene Glycol | 26.1 | 150 | | | | | | | | | | |
| | Glycerin | 896 | | 100 | | 200 | | 100 | 150 | | 250 | | 200 |
| | Ethylene Glycol | 25.2 | | | 80 | | | | | 50 | | | |
| | Propytene Glycol | 40.8 | | | | | 200 | | | | | | |
| | PEG#400 | 90.3 | | | | | | | | | | 150 | |
| | Water-Soluble Plasticizer 2 (Mw < 500) | - | | | | | | | | | | | |
| | Diethylene Glycol Monomethyl Ether | 0.8 | | | | | 100 | | | | | | |
| | Water-Soluble Plasticizer 3 (Mw > 500) | - | | | | | | | | | | | |
| | PEG#600 | 128 | | | | | | | | | | | |
| | PEG#1000 | Solid | | | | | | | | | | | |
| | Polyglycerin | 37890 | | | | | | | | | | | |
| | PPG#3000 | 537 | | | | | | | | | | | |

(continued)

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| (C) Fluxing Agent (pts.mass) | Salicylic Acid | 5 | | | | | | 8 | | | 3 | |
| | Adipic Acd | | 7 | | 5 | | 7.5 | | | 5 | | |
| | Succinic Acid | | | 5 | | | | | | | | |
| | Maleic Acid | | | | | 3 | | | | | | |
| | Glutaric Acd | | | | | | | | 10 | | | 24 |
| Solvent (pts.mass) | Methanol | 150 | | | | | | | | | | |
| | Ethanol | | | | | | | | | | | |
| | Water | 150 | 300 | 300 | 200 | 200 | 475 | 525 | 100 | 1000 | 2000 | 1000 |
| Sum | | 555 | 507 | 485 | 505 | 603 | 832.5 | 933 | 260 | 1355 | 2253 | 1324 |

PVA: vinyl alcohol-based polymer
PVP: vinylpyrrolidone-based polymer
CMC: carboxymethyl cellulose
SP500: hydroxyethyl cellulose

[Table 3]

| | | | Example 12 | Example 13 | Example 14 | Example 15 | Example 16 | Comparative Example 1 | Comparative Example 2 | Comparative Example 3 |
|---|---|---|---|---|---|---|---|---|---|---|
| (A) Water-Soluble Sticking Agent (pts.mass) | PVA | | | 250 | 250 | | 250 | 250 | 100 | |
| | PVP | | 100 | | | 100 | | | | 100 |
| | CMC | | | | | | | | | |
| | SP500 | | | | | | | | | |
| | Pullulan | | | | | | | | | |
| (B) Water-Soluble Plasticizer (pts.mass) | Water-Soluble Plasticizer 1 (Mw < 500) | Viscosity (mPa.s) | | | | | | | | |
| | Diethylene Glycol | 26.1 | | | | | | | | |
| | Glycerin | 896 25.2 | | 62.5 | 75 | | | | | |
| | Propylene | | | | | | | | 18 | |
| | Glycol | 40.8 | | | | | | | | |
| | PEG#400 | 90.3 | | | | | | | | |
| | Water-Soluble Plasticizer 2 (Mw < 500) | - | | | | | | | | |
| | Dimethylene Glycol Monomethy Ether | 0.8 | | | | | | | | |
| | Water-Soluble Plasticizer 3 (Mw > 500) | - | | | | | | | | |
| | PEG#600 | 128 | 200 | | | | | | | |
| | PEG#1000 | Solid | | | | | | | | 200 |
| | Polyglycerin | 37890 | | | | | 200 | | | |
| | PPG#3000 | 537 | | | | | | | | |

(continued)

| | | Example 12 | Example 13 | Example 14 | Example 15 | Example 16 | Comparative Example 1 | Comparative Example 2 | Comparative Example 3 |
|---|---|---|---|---|---|---|---|---|---|
| (C) Fluxing Agent (pts.mass) | Salicylic Acid | | | | | | | | |
| | Adipic Acid | | | | | | 8.5 | | |
| | Succinic Acid | | | | | | | | |
| | Maleic Acid | | | | | | | | |
| | Glutaric Acid | 24 | 10 | 10 | 24 | 10 | | 5 | 24 |
| Solvent (pts.mass) | Methanol | | | | | | | | |
| | Ethanol | | | | 800 | | | | |
| | Water | 800 | 475 | | | 475 | 375 | 200 | 800 |
| Sum | | 1124 | 797.5 | 810 | 1124 | 935 | 633.5 | 323 | 1124 |

[Table 4]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| (A) Water-Soluble Stickig Agent (mass%) | PVA | 38.2 | 47.3 | 53.1 | 31.8 | 23.8 | 68.9 | 60.2 | | | | |
| | PVP | | | | | | | | 61.5 | | | |
| | CMC | | | | | | | | | 27.2 | | |
| | SP500 | | | | | | | | | | 38.5 | |
| | Pullulan | | | | | | | | | | | 29.9 |
| Water (mass%) | | 3.0 | 3.0 | 3.0 | 3.0 | 3.0 | 3.0 | 3.0 | 3.0 | 3.0 | 3.0 | 3.0 |

(continued)

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| Plasticizer (mass%) | Water-Soluble Plasticizer 1 (Mw < 500) | Viscosity (mPa s) | | | | | | | | | | | |
| | Diethylene Glycol | 26.1 | 56.8 | | | | | | | | | | |
| | Glycerin | 896 | | 46.3 | | 63.6 | | 26.0 | 34.8 | | 68.4 | | 59.7 |
| | Ethylene Glycol | 25.2 | | | 41.2 | | | | | 29.3 | | | |
| | Propylene Gycol | 40.8 | | | | | | | | | | | |
| | (B) Water-Soluble PEG#400 90.3 | | | | | | | | | | | 57.3 | |
| | Water-Soluble Plasticizer 2 (Mw < 500) | | | | | | | | | | | | |
| | Diethylene Glycol Monomethyl Ether | 0.8 | | | | | 23 8 | | | | | | |
| | Water-Soluble Plasticizer 3 (Mw > 500) | - | | | | | | | | | | | |
| | PEG#600 | 128 | | | | | | | | | | | |
| | PEG#1000 | Sold | | | | | | | | | | | |
| | Polyglycerin | 37890 | | | | | | | | | | | |
| | PPG#3000 | 537 | | | | | | | | | | | |

(continued)

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| (C) Fluxing Agent (mass%) | Salicylic Acid | 2.0 | | | | | | 2.0 | | | 1.2 | |
| | Adipic Acd | | 3.4 | | 1.6 | | 2.1 | | | 1.4 | | |
| | Succinic Acid | | | 2.7 | | | | | | | | |
| | Maleic Acid | | | | | 0.8 | | | | | | |
| | Glutaric Acid | | | | | | | | 6. 2 | | | 7.4 |
| Sum | | 100 | 100 | 100 | 100 | 100 | 100 | 100 | 100 | 100 | 100 | 100 |
| (B)/(A) | | 1.5 | 1.0 | 0.8 | 2.0 | 3.0 | 0.4 | 0.6 | 0.5 | 2.5 | 1.5 | 2.0 |
| Transferability | | A | A | B | A | A | A | B | B | A | A | A |
| Flux Activity | | A | A | A | A | A | A | A | A | B | A | A |
| Washability | Ion Exchanged Water | C | A | A | B | A | A | A | A | B | B | B |
| | Flux Cleaning Fluid | A | A | A | A | A | A | A | A | B | B | B |
| | Enzyme Cleaning Fluid 1 | - | - | - | - | - | - | - | - | - | - | A |
| | Enzyme Cleaning Fluid 2 | - | - | - | - | - | - | - | - | A | A | - |
| Process Suitability | | A | A | A | A | A | A | A | A | B | A | A |

[Table 5]

| | | Example 12 | Example 13 | Example 14 | Example 15 | Example 16 | Comparative Example 1 | Comparative Example 2 | Comparative Example 3 |
|---|---|---|---|---|---|---|---|---|---|
| (A) Water-Sobble Sticking Agent (mass%) | PVA | | 75.2 | 72.4 | | 52.7 | 93.7 | 80.3 | |
| | PVP | 29.9 | | | 30.8 | | | | 29.9 |
| | CMC | | | | | | | | |
| | SP500 | | | | | | | | |
| | Pullulan | | | | | | | | |
| Water (mass%) | | 3.0 | 3.0 | 3.0 | 0.0 | 3.0 | 3.0 | 3.0 | 3.0 |

(continued)

| | | | Example 12 | Example 13 | Example 14 | Example 15 | Example 16 | Comparative Example 1 | Comparative Example 2 | Comparative Example 3 |
|---|---|---|---|---|---|---|---|---|---|---|
| (B) Water-Sobble Plasticizer (mass%) | Water-Soluble Plasticizer 1 (Mw < 500) | Viscosity (mPa.s) | | | | | | | | |
| | Diethylene Glycol | 26.1 | | | | | | | | |
| | Glycerin | 896 | | 18.8 | 21.7 | | | | | |
| | Ethylene Glycol | 25.2 | | | | | | | 12.6 | |
| | Propylene Glycol | 40.8 | | | | | | | | |
| | PEG#400 | 90.3 | | | | | | | | |
| | Water-Soluble Plasticizer 2 (Mw < 500) | - | | | | | | | | |
| | Diethylene Glycol Monomethyl Ether | 0.8 | | | | | | | | |
| | Water-Soluble Plasticizer 3 (Mw > 500) | - | | | | | | | | |
| | PEG#600 | 128 | 59.9 | | | | | | | |
| | PEG#1000 | Solid | | | | | | | | 59.9 |
| | Polyglycerin | 37890 | | | | | | | | |
| | PPG#3000 | 537 | | | | 61.8 | | | | |
| | Salicylic Acid | | | | | | | | | |

(continued)

| | | Example 12 | Example 13 | Example 14 | Example 15 | Example 16 | Comparative Example 1 | Comparative Example 2 | Comparative Example 3 |
|---|---|---|---|---|---|---|---|---|---|
| (C) Fluxing Agent (mass%) | Adipic Acid | | | | | | 3.3 | | |
| | Succinic | | | | | | | | |
| | Acid Maleic Acid | | | | | | | | |
| | Glutaric Acid | 7.2 | 3 | 2.9 | 7.4 | 2.1 | | 4.1 | 7.2 |
| Sum | | 100 | 100 | 100 | 100 | 100 | 100 | 100 | 100 |
| (B)/(A) | | 2 | 0.25 | 0.3 | 2 | 0.8 | 0 | 0.18 | 2 |
| Transferability | | A | B | B | B | B | C | C | Poor |
| Flux Activity | | A | A | A | A | A | A | A | Poor |
| Washability | Ion Exchanged Water | A | A | A | B | A | A | B | Poor |
| | Flux Cleaning Fluid | A - - | A | A | A | A | A | A | Poor |
| | Enzyme Cleaning Fluid 1 | - | - | - | - | - | - | - | - |
| | Enzyme Cleaning Fluid 2 | - | - | - | - | - | - | - | - |
| Process Suitability | | A | A | A | A | A | C | C | Poor |

From the comparison between Examples and Comparative Example 1, it is seen that when the (B) water-soluble plasticizer is contained, the transferability is improved, and thus the process suitability is also improved.

From the comparison between Examples and Comparative Example 2, it is seen that when the ratio ((B)/(A)) of the content of the (B) water-soluble plasticizer to the content of the (A) water-soluble sticking agent is 0.2 or more, the transferability is improved, and thus the process suitability is also improved. While the ratio (B)/(A) was 0.25 and the transferability was satisfactory in Example 13, the ratio (B)/(A) was 0.18, the transferability was poor, and the process suitability was also poor in Comparative Example 2.

From the comparison between Examples and Comparative Example 3, it is seen that when the (B) water-soluble plasticizer is in a liquid state at ordinary temperature (25°C), the effect of the present invention is provided. It is seen that when the (B) water-soluble plasticizer having the viscosity at 25°C of 50000 mPa.s or less or the molecular weight of 5000 or less is contained, both the transferability and the flux activity are improved, and thus the process suitability is also improved.

[Related Application]

This application claims priority under Article 4 of the Paris Convention or Article 41 of the Japanese Patent Law on Patent Application No. 2021-006770 filed in Japan on January 19, 2021. The contents of the basic application is entirely incorporated herein by reference.

INDUSTRIAL APPLICABILITY

The present invention can provide the flux sheet excellent in shock absorbency and stickiness/adhesiveness and excellent in water washability having the flux activity.

DESCRIPTION OF REFERENCE SIGNS

1A, 1B Transfer destination substrate
11A, 11B Flux sheet for semiconductor transfer
12A, 12B Wiring board
2A, 2B, 2C, 2D Transfer source substrate
21A, 21B, 21C, 21D Semiconductor device
22A, 22B, 22C, 22D Sticking layer
23A, 23B, 23C, 23D Device temporarily holding substrate
3 Energy beam

## Claims

1. A flux sheet for semiconductor transfer, comprising:

   a (A) water-soluble sticking agent; and
   a (B) water-soluble plasticizer (excluding the component (A)), wherein
   the (B) water-soluble plasticizer has a viscosity of 50000 mPa.s or less at ordinary temperature (25°C), and a ratio ((B)/(A)) of a content of the (B) water-soluble plasticizer to a content of the (A) water-soluble sticking agent is 0.2 or more.

2. A flux sheet for semiconductor transfer, comprising:

   a (A) water-soluble sticking agent; and
   a (B) water-soluble plasticizer (excluding the component (A)), wherein
   the (B) water-soluble plasticizer is in a liquid state at ordinary temperature (25°C) and has a molecular weight of 5000 or less, and a ratio ((B)/(A)) of a content of the (B) water-soluble plasticizer to a content of the (A) water-soluble sticking agent is 0.2 or more.

3. The flux sheet for semiconductor transfer according to claim 1 or 2, comprising
   a (C) fluxing agent (excluding the component (A) and the component (B)).

**4.** The flux sheet for semiconductor transfer according to claim 1 or 2, wherein the (A) water-soluble sticking agent contains at least one water-soluble sticking agent selected from the group consisting of a vinyl alcohol-based polymer, a vinylpyrrolidone-based polymer, an acrylic-based polymer, and saccharides.

**5.** The flux sheet for semiconductor transfer according to claim 1 or 2, wherein the vinyl alcohol-based polymer has an oxyalkylene structure.

**6.** The flux sheet for semiconductor transfer according to claim 1 or 2, wherein the (B) water-soluble plasticizer has a boiling point at 120°C or more.

**7.** The flux sheet for semiconductor transfer according to claim 1 or 2, wherein the (B) water-soluble plasticizer contains at least one selected from glycerin, diglycerin, polyethylene glycol, ethylene glycol, propylene glycol, and polypropylene glycol.

**8.** The flux sheet for semiconductor transfer according to claim 1 or 2, wherein

the (A) water-soluble sticking agent includes saccharides, and
the (B) water-soluble plasticizer (excluding the component (A)) has a boiling point at 200°C or more.

**9.** The flux sheet for semiconductor transfer according to claim 1 or 2, wherein the (C) fluxing agent includes a compound having a carboxyl group.

**10.** The flux sheet for semiconductor transfer according to claim 1 or 2, wherein a semiconductor to be transferred is a light-emitting diode.

**11.** A method for manufacturing an electronic component, the method using the flux sheet for semiconductor transfer according to claim 1 or 2.

Fig. 1

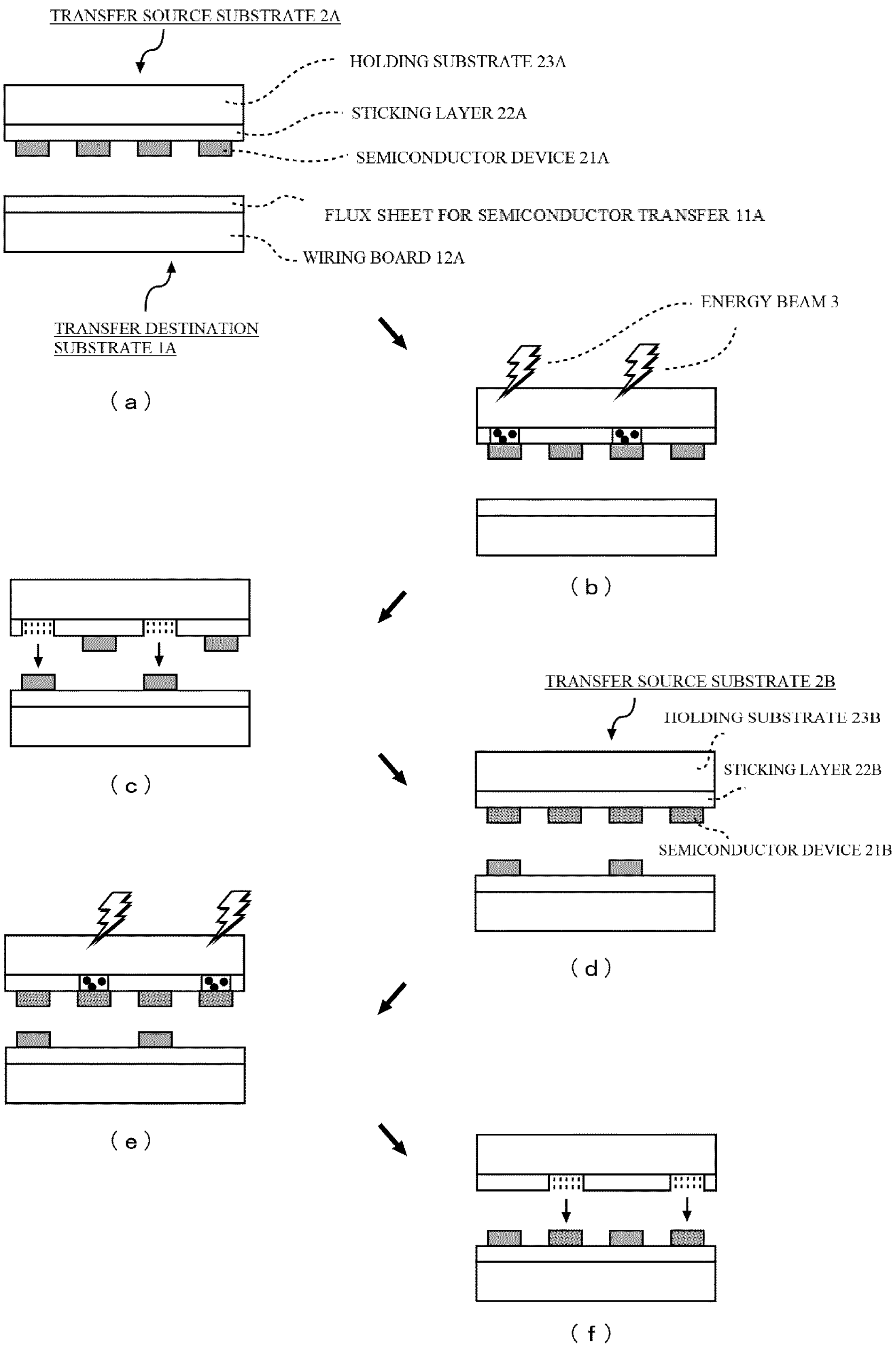

TRANSFER SOURCE SUBSTRATE 2A
HOLDING SUBSTRATE 23A
STICKING LAYER 22A
SEMICONDUCTOR DEVICE 21A
FLUX SHEET FOR SEMICONDUCTOR TRANSFER 11A
WIRING BOARD 12A
TRANSFER DESTINATION SUBSTRATE 1A
(a)
ENERGY BEAM 3
(b)
(c)
TRANSFER SOURCE SUBSTRATE 2B
HOLDING SUBSTRATE 23B
STICKING LAYER 22B
SEMICONDUCTOR DEVICE 21B
(d)
(e)
(f)

Fig. 2

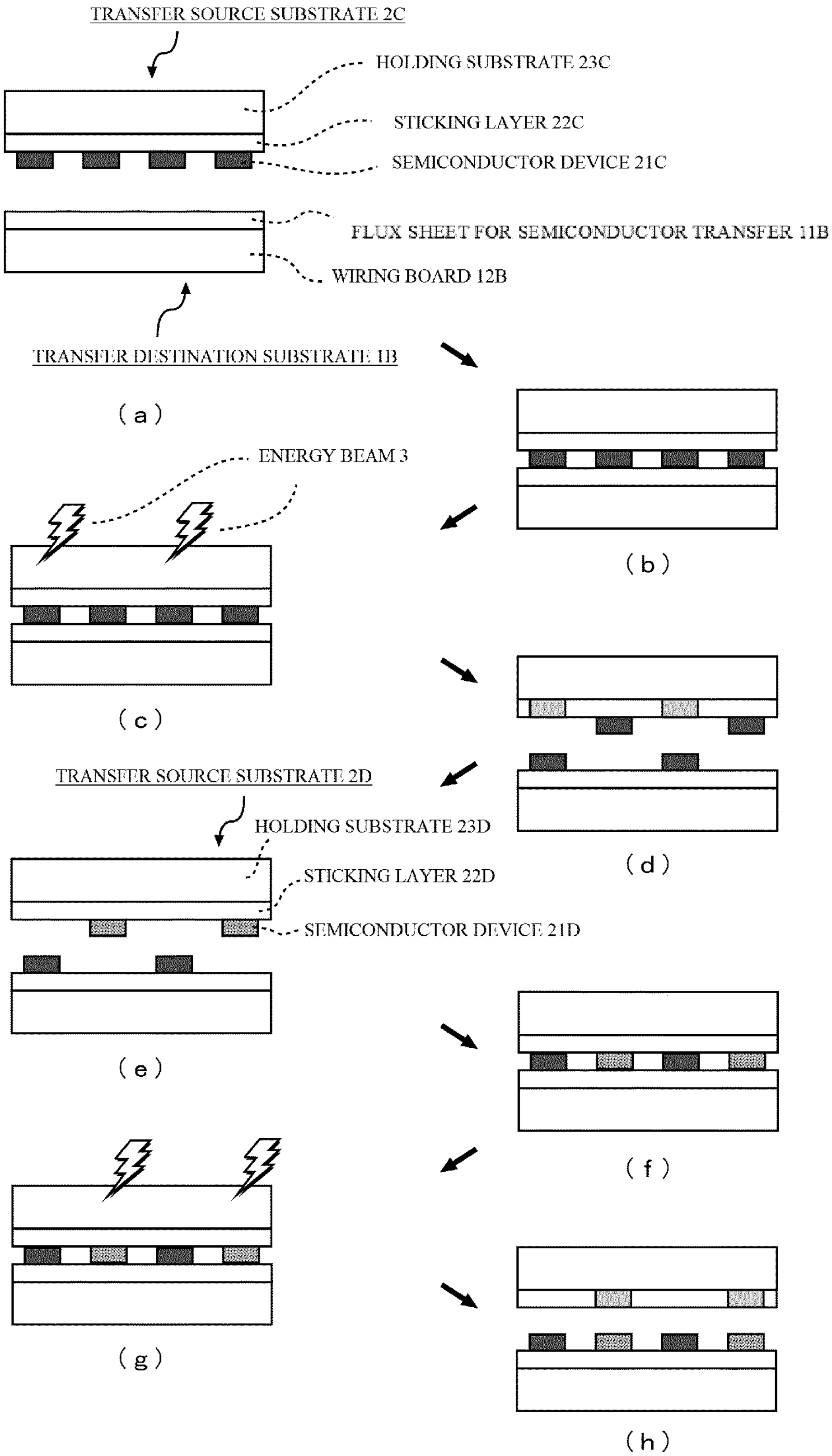
TRANSFER SOURCE SUBSTRATE 2C
HOLDING SUBSTRATE 23C
STICKING LAYER 22C
SEMICONDUCTOR DEVICE 21C
FLUX SHEET FOR SEMICONDUCTOR TRANSFER 11B
WIRING BOARD 12B
TRANSFER DESTINATION SUBSTRATE 1B
(a)
ENERGY BEAM 3
(b)
(c)
(d)
TRANSFER SOURCE SUBSTRATE 2D
HOLDING SUBSTRATE 23D
STICKING LAYER 22D
SEMICONDUCTOR DEVICE 21D
(e)
(f)
(g)
(h)

Fig. 3

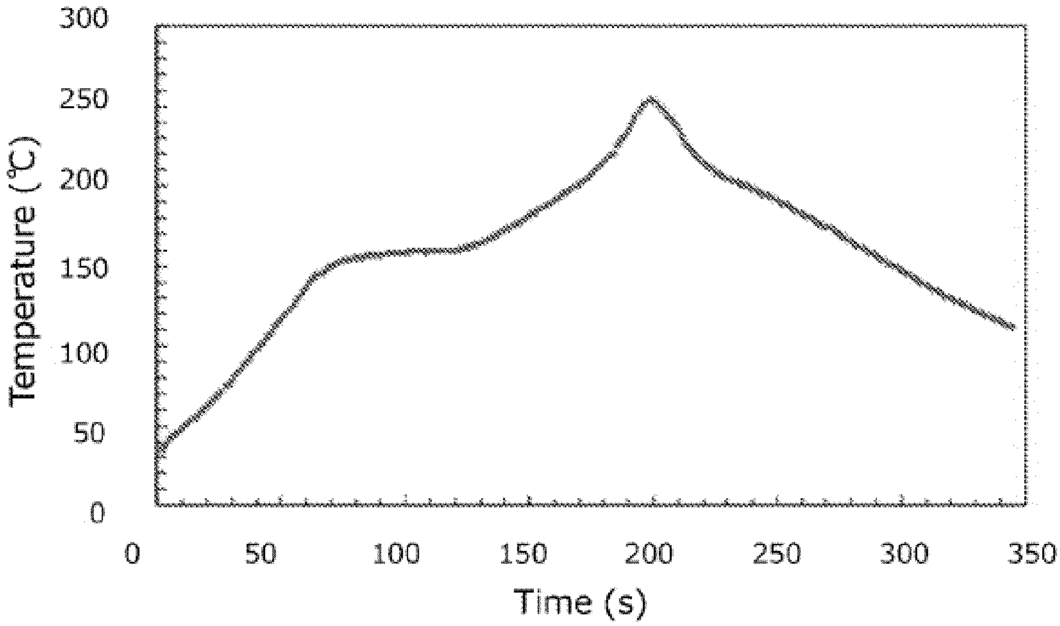
Temperature (℃)
300
250
200
150
100
50
0
0
50
100
150
200
250
300
350
Time (s)

## INTERNATIONAL SEARCH REPORT

International application No.
**PCT/JP2022/001680**

**A. CLASSIFICATION OF SUBJECT MATTER**

***B23K 35/363***(2006.01)i; ***H01L 33/48***(2010.01)i
FI: B23K35/363 D; H01L33/48

According to International Patent Classification (IPC) or to both national classification and IPC

**B. FIELDS SEARCHED**

Minimum documentation searched (classification system followed by classification symbols)

B23K35/363; H01L33/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2013-110403 A (HITACHI CHEMICAL CO LTD) 06 June 2013 (2013-06-06) claims, paragraphs [0047]-[0049], examples | 1-4, 6, 7, 9-11<br>1-11 |
| X<br>Y | JP 2013-110405 A (HITACHI CHEMICAL CO LTD) 06 June 2013 (2013-06-06) claims, paragraphs [0057], [0058], examples | 1-4, 6, 7, 9-11<br>1-11 |
| Y | JP 2013-110402 A (HITACHI CHEMICAL CO LTD) 06 June 2013 (2013-06-06) claims | 4 |
| Y | JP 2014-168791 A (HITACHI CHEMICAL CO LTD) 18 September 2014 (2014-09-18) claims, paragraphs [0025]-[0028] | 4, 5 |
| Y | WO 2020/116403 A1 (NAGASE CHEMTEX CORP) 11 June 2020 (2020-06-11) claims, paragraph [0041] | 5, 8 |
| Y | WO 2016/043092 A1 (SONY CORP) 24 March 2016 (2016-03-24) paragraphs [0033]-[0041], fig. 12, 13 | 1-11 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 March 2022** | **05 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2022/001680**

**C. DOCUMENTS CONSIDERED TO BE RELEVANT**

| Category* | Citation of document, with indication, where appropriate, of the relevant passages | Relevant to claim No. |
|---|---|---|
| A | CN 111055045 A (WUHAN FENGFAN ELECTROCHEMICAL TECHNOLOGY CO., LTD.) 24 April 2020 (2020-04-24)<br>entire text | 1-11 |

Form PCT/ISA/210 (second sheet) (January 2015)

**INTERNATIONAL SEARCH REPORT**
**Information on patent family members**

International application No.
**PCT/JP2022/001680**

| Patent document cited in search report | Publication date (day/month/year) | Patent family member(s) | Publication date (day/month/year) |
|---|---|---|---|
| JP 2013-110403 A | 06 June 2013 | US 2014/0252607 A1<br>claims, paragraphs [0094]-[0096], examples<br>TW 201336004 A<br>CN 103907179 A<br>KR 10-2014-0084095 A | |
| JP 2013-110405 A | 06 June 2013 | US 2014/0252607 A1<br>claims, examples, paragraph [0092]<br>TW 201336004 A<br>CN 103907179 A<br>KR 10-2014-0084095 A | |
| JP 2013-110402 A | 06 June 2013 | US 2014/0252607 A1<br>claims<br>TW 201336004 A<br>CN 103907179 A<br>KR 10-2014-0084095 A | |
| JP 2014-168791 A | 18 September 2014 | (Family: none) | |
| WO 2020/116403 A1 | 11 June 2020 | CN 113165092 A<br>KR 20210097105 A | |
| WO 2016/043092 A1 | 24 March 2016 | US 2017/0287823 A1<br>paragraphs [0090]-[0099]<br>CN 106716612 A | |
| CN 111055045 A | 24 April 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002261335 A
- JP 2010161221 A
- JP 2021006770 A